(19) Europäisches Patentamt
European Patent Office
Office européen des brevets

(11) EP 4 589 594 A1

(12) EUROPEAN PATENT APPLICATION
published in accordance with Art. 153(4) EPC

(43) Date of publication:
23.07.2025 Bulletin 2025/30

(51) International Patent Classification (IPC):
G11C 16/30 (2006.01)    G11C 7/04 (2006.01)
H03M 1/78 (2006.01)

(21) Application number: 22958849.6

(22) Date of filing: 16.09.2022

(52) Cooperative Patent Classification (CPC):
G11C 7/04; G11C 16/30; H03M 1/78

(86) International application number:
PCT/JP2022/034749

(87) International publication number:
WO 2024/057529 (21.03.2024 Gazette 2024/12)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: Kioxia Corporation
Tokyo 108-0023 (JP)

(72) Inventor: KOBAYASHI, Osamu
Tokyo 108-0023 (JP)

(74) Representative: Hoffmann Eitle
Patent- und Rechtsanwälte PartmbB
Arabellastraße 30
81925 München (DE)

(54) **SEMICONDUCTOR DEVICE AND MEMORY DEVICE**

(57) According to one embodiment, a semiconductor device (160) includes: an operational amplifier (50) including a first input terminal (IT1), a second input terminal (IT2), and an output terminal (OT), the operational amplifier (50) that outputs a first voltage (Vout) from the output terminal; a first resistor (51) including one end connected to the first input terminal and an other end connected to the output terminal; a plurality of second resistors (55<1> to 55<M>) including one end connected to the first input terminal, the plurality of second resistors connected in series; a plurality of switches (SW<1> to SW<M>) each including one end connected to a first node (NDc) between two adjacent resistors of the plurality of second resistors and an other end connected to a second node (NDd), the plurality of switches that receives a digital code (CD); and a current source circuit (59) connected between the second node and a third node (NDz), wherein a switch out of the plurality of switches is turned on based on the digital code, and the current source circuit causes a first current (Ir) to flow from a part or all of the plurality of second resistors to the third node via the switch in an on state.

F I G. 7

Processed by Luminess, 75001 PARIS (FR)

EP 4 589 594 A1

**Description**

FIELD

Embodiments relate to a semiconductor device and a memory device.

BACKGROUND

A digital-analog conversion circuit and an analog-digital conversion circuit are used in various semiconductor devices.

CITATION LIST

PATENT LITERATURE

Patent Literature 1: Japanese Patent No. 2002-76897

SUMMARY

According to one embodiment, a semiconductor device includes: an operational amplifier including a first input terminal, a second input terminal, and an output terminal, the operational amplifier that outputs a first voltage from the output terminal; a first resistor including one end connected to the first input terminal and an other end connected to the output terminal; a plurality of second resistors including one end connected to the first input terminal, the plurality of second resistors connected in series; a plurality of switches each including one end connected to a first node between two adjacent resistors of the plurality of second resistors and an other end connected to a second node, the plurality of switches that receives a digital code; and a current source circuit connected between the second node and a third node, wherein a switch out of the plurality of switches is turned on based on the digital code, and the current source circuit causes a first current to flow from a part or all of the plurality of second resistors to the third node via the switch in an on state.

BRIEF DESCRIPTION OF THE DRAWINGS

FIG. 1 is a block diagram illustrating a configuration example of a semiconductor device of a first embodiment.
FIG. 2 is a circuit diagram illustrating a configuration example of a memory cell array of the semiconductor device of the first embodiment.
FIG. 3 is a cross-sectional view illustrating a structure example of the semiconductor device of the first embodiment.
FIG. 4 is a top view illustrating a structure example of a memory cell of the semiconductor device of the first embodiment.
FIG. 5 is a graph for describing a relationship between a threshold voltage of the memory cell and data.
FIG. 6 is a schematic diagram illustrating a configuration example of a digital-analog conversion circuit and a driver circuit of the semiconductor device of the first embodiment.
FIG. 7 is a circuit diagram illustrating the configuration example of the digital-analog conversion circuit and the driver circuit of the semiconductor device of the first embodiment.
FIG. 8 is a circuit diagram illustrating a configuration example of a certain circuit in the semiconductor device of the first embodiment.
FIG. 9 is a circuit diagram illustrating the configuration example of a certain circuit in the semiconductor device of the first embodiment.
FIG. 10 is a circuit diagram illustrating the configuration example of a certain circuit in the semiconductor device of the first embodiment.
FIG. 11 is a diagram for describing an operation example of the semiconductor device of the first embodiment.
FIG. 12 is a circuit diagram illustrating a configuration example of a digital-analog conversion circuit and a driver circuit of a semiconductor device of a second embodiment.
FIG. 13 is a circuit diagram illustrating a configuration example of a digital-analog conversion circuit and a driver circuit of a semiconductor device of a third embodiment.
FIG. 14 is a circuit diagram illustrating a configuration example of a digital-analog conversion circuit and a driver circuit of a semiconductor device of a fourth embodiment.
FIG. 15 is a circuit diagram illustrating a configuration example of a certain circuit of the semiconductor device of the fourth embodiment.

FIG. 16 is a block diagram illustrating a configuration example of a semiconductor device of a fifth embodiment.

FIG. 17 is a block diagram illustrating a configuration example of a semiconductor device of a sixth embodiment.

FIG. 18 is a block diagram illustrating a configuration example of a semiconductor device of a seventh embodiment.

DETAILED DESCRIPTION

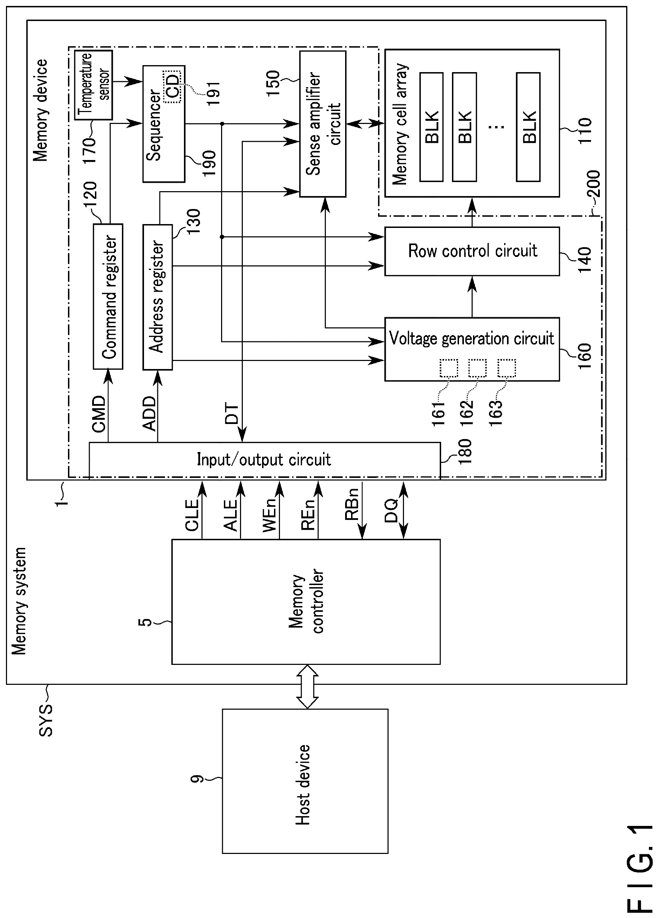

A semiconductor device of an embodiment will be described with reference to FIGS. 1 to 18.

(1) First Embodiment

A semiconductor device of a first embodiment will be described with reference to FIGS. 1 to 11.

(a) Configuration Example

<Overall Configuration>

An overall configuration of the semiconductor device of the first embodiment will be described with reference to FIGS. 1 to 3.

FIG. 1 is a block diagram for describing a configuration example of a system SYS including the semiconductor device 1 of the present embodiment.

As illustrated in FIG. 1, the semiconductor device 1 of the present embodiment is a memory device 1.

The memory device 1 is provided in the memory system SYS.

The memory system SYS is connected to a host device 9 via a host bus. The memory system SYS might be requested by the host device 9 to write data, read data, and erase data.

The host device 9 is, for example, a personal computer, a server or the like. The host bus is, for example, a bus based on an interface standard such as an SD (registered trademark) interface, a serial attached small computer system interface (SCSI) (SAS), a serial advanced technology attachment (ATA) (SATA), a peripheral component interconnect express (PCIe), or a non-volatile memory express (NVMe). Note that, the memory system SYS may be connected to the host device 9 by wireless communication.

The memory system SYS includes the memory device 1 of the present embodiment and a memory controller 5.

The memory controller 5 is electrically coupled to the memory device 1. The memory controller 5 transmits a command CMD, an address ADD, and a plurality of control signals to the memory device 1.

The memory device 1 is a non-volatile semiconductor memory device. For example, the memory device 1 of the present embodiment is a NAND flash memory 1.

The memory device 1 receives the command CMD, the address ADD, and the plurality of control signals. Data DT is transferred between the memory device 1 and the memory controller 5. Hereinafter, the data DT transferred from the memory controller 5 to the memory device 1 at the time of write sequence is referred to as write data. Write data DT is written in the memory device 1. The data DT transferred from the memory device 1 to the memory controller 5 at the time of read sequence is referred to as read data. Read data DT is read from the memory device 1.

The memory device 1 includes, for example, a memory cell array 110, a command register 120, an address register 130, a row control circuit 140, a sense amplifier circuit 150, a voltage generation circuit 160, a temperature sensor 170, an input/output circuit 180, and a sequencer 190.

The memory cell array 110 stores data. A plurality of bit lines and a plurality of word lines are provided in the memory cell array 110. The memory cell array 110 includes a plurality of blocks BLK. Each block BLK is a set of a plurality of memory cells. Each memory cell is associated with one bit line and one word line. The memory cell array 110 includes a plurality of select gate lines for selecting a control unit in the memory cell array 110.

An internal configuration of the memory cell array 110 will be described later.

The command register 120 temporarily stores the command CMD from the memory controller 5. The command CMD is, for example, a signal including an order for causing the sequencer 190 to execute the read sequence, the write sequence, the erase sequence and the like.

The address register 130 temporarily stores an address (select address) ADD from the memory controller 5. The address ADD includes, for example, a block address, a page address (word line address), a column address and the like. For example, the block address, the page address, and the column address are used to select the block BLK, the word line, and the bit line (column), respectively. The block selected based on the block address is hereinafter referred to as a selected block. The word line selected based on the page address is referred to as a selected word line.

The row control circuit 140 controls an operation regarding a row of the memory cell array 110. The row controller 140 selects one block BLK in the memory cell array 110 based on the block address. The row control circuit 140 transfers, for example, a voltage applied to an interconnect corresponding to the selected word line to the selected word line in the selected block BLK. The row control circuit 140 controls whether to select or not the select gate line based on the address ADD. The row control circuit 140 includes a word line switch, a row decoder and the like.

The sense amplifier circuit 150 controls an operation regarding a column of the memory cell array 110. In the write sequence, the sense amplifier circuit 150 applies a voltage to each of the bit lines provided in the memory cell array 110 according to the write data DT from the memory controller 5. In the read sequence, the sense amplifier circuit 150 determines the data stored in the memory cell based on presence or absence of generation of a current or a fluctuation in potential of the bit line. The sense amplifier circuit 150 transfers data based on a determination result to the memory controller 5 as read data. The sense amplifier circuit 150 includes a sense amplifier unit, a data latch circuit, a cache circuit and the like.

The voltage generation circuit 160 generates a plurality of voltages for various operations of the memory device 1 in various operation sequences such as the read sequence, the write sequence, and the erase sequence. The voltage generation circuit 160 outputs the generated voltage to each circuit. The voltage generation circuit 160 can apply a predetermined voltage to an interconnect corresponding to the word line, the bit line and the like based on the address ADD. The voltage generation circuit 160 includes, for example, a charge pump circuit 161, a driver circuit 162, a digital-analog conversion circuit 163 and the like.

The input/output circuit 180 functions as an interface circuit on a memory device 1 side between the memory device 1 and the memory controller 5. In a case where the memory device 1 is the NAND flash memory, the input/output circuit 180 communicates with the memory controller 5 based on a NAND interface standard such as an open NAND flash interface (ONFi). A command latch enable signal CLE, an address latch enable signal ALE, a write enable signal WEn, a read enable signal REn, a ready/busy signal RBn, an input/output signal DQ and the like are used for communication between the memory device 1 and the memory controller 5.

The command latch enable signal CLE is a signal indicating that the input/output signal DQ received by the memory device 1 is the command CMD. The address latch enable signal ALE is a signal indicating that the signal DQ received by the memory device 1 is the address ADD. The write enable signal WEn is a signal that orders the memory device 1 to input the input/output signal DQ. The read enable signal REn is a signal that orders the memory device 1 to output the input/output signal DQ.

The ready/busy signal RBn is a signal that notifies the memory controller 5 by the memory device 1 whether the memory device 1 is in a ready state in which an order from the memory controller 5 is accepted or in a busy state in which an order is not accepted.

The input/output signal DQ is, for example, a signal set having an 8-bit width. The input/output signal DQ may include the command CMD, the address ADD, the data DT and the like.

The temperature sensor 170 measures temperature of a chip (or package) of the memory device 1. The temperature sensor 170 transmits a measurement result of the temperature to the sequencer 190.

Note that, the temperature sensor 170 may be provided in the sequencer 190.

The sequencer 190 controls an operation of an entire memory device 1. For example, the sequencer 190 controls each circuit based on the command CMD in the command register 120.

For example, the sequencer 190 generates a code (hereinafter, also referred to as a digital code) CD based on the measurement result of the temperature. The code CD is indicated by a digital value of two or more bits. The sequencer 190 transmits the generated code CD to the voltage generation circuit 160. The voltage generation circuit 160 controls magnitude of the voltage used for the operation of the memory device 1 based on the received code CD.

For example, the sequencer 190 includes a digital control circuit 191. The digital control circuit 191 generates various digital signals such as the code CD.

Note that, the code CD may be directly transmitted from the temperature sensor 170 to the voltage generation circuit 160.

Hereinafter, each of the circuits 120 to 190 excluding the memory cell array 110 or a set of the circuits in the memory device 1 is referred to as a CMOS circuit (or a peripheral circuit) 200.

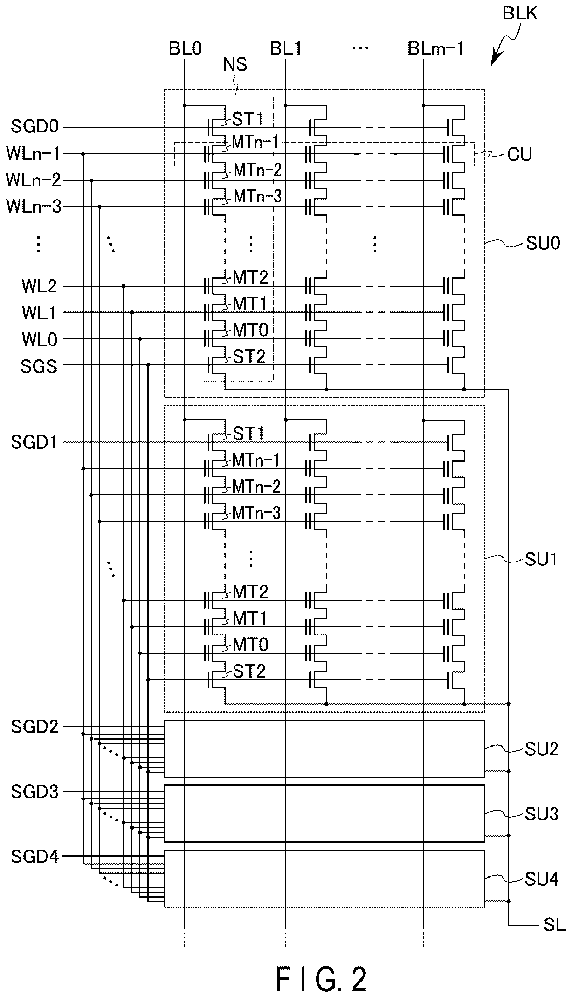

FIG. 2 is a circuit diagram illustrating a circuit configuration of a certain block BLK in the memory cell array 110.

As illustrated in FIG. 2, one block BLK includes a plurality of (for example, five) string units SU (SU0, SU1, SU2, SU3, and SU4). Each string unit SU includes a plurality of NAND strings NS. The number of blocks in the memory cell array 110, the number of string units in the block BLK, and the number of NAND strings in the string unit SU are optional.

Each NAND string NS includes a plurality of memory cells MT (MT0, MT1, MT2, ..., MTn-3, MTn-2, and MTn-1) and a plurality of select transistors ST1 and ST2. n is a natural number not smaller than 2. The plurality of memory cells MT is connected in series between a source of the select transistor ST1 and a drain of the select transistor ST2.

The memory cell MT stores data in a substantially non-volatile manner.

The memory cell (also referred to as a memory cell transistor) MT is a field-effect transistor including a control gate and a charge storage layer.

Gates of the select transistors ST1 in each of the string units SU is connected to one corresponding select gate line SGD out of a plurality of select gate lines SGD (SGD0, SGD1, SGD2, SGD3, and SGD4), respectively.

Gates of the select transistors ST2 in the respective string units SU are commonly connected to, for example, a select gate line SGS. The gates of the select transistors ST2 may be connected to different select gate lines SGS for each string unit SU.

The control gates of the memory cells MT0, MT1, MT2, ..., MTn-3, MTn-2, and MTn-1 belonging to the same block BLK are connected to one corresponding word line WL out of the plurality of word lines WL (WL0, WL1, WL2, ..., WLn-3, WLn-2, and WLn-1), respectively.

Drains of the select transistors ST1 of the NAND strings NS belonging to the same column in the memory cell array 110 are connected to one corresponding bit line BL out of the plurality of bit lines BL (BL0, BL1, ..., and BLm-1), respectively. m is a natural number not smaller than 2.

Sources of a plurality of select transistors ST2 are commonly connected to a source line SL.

The string unit SU is an aggregate of the NAND strings NS connected to different bit lines BL and connected to the same select gate line SGD.

The block BLK is an aggregate of the plurality of string units SU sharing the plurality of word lines WL. The memory cell array 110 is an aggregate of the plurality of blocks BLK sharing the plurality of bit lines BL.

Hereinafter, a set of memory cells MT (memory cell group) commonly connected to the same word line WL in each string unit SU is also referred to as a cell unit CU (or a memory group).

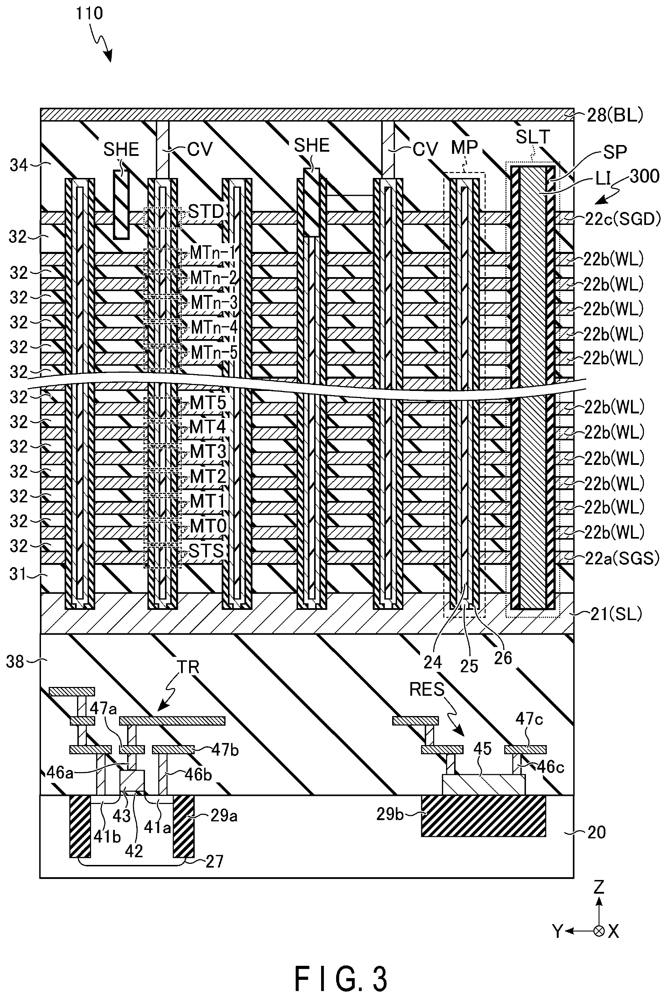

FIG. 3 is a cross-sectional view illustrating a structure example of the memory cell array in a case where the semiconductor device 1 of the present embodiment is the NAND flash memory.

As illustrated in FIG. 3, the memory cell array 110 includes a semiconductor substrate (hereinafter, also simply referred to as a substrate) 20, conductive layers 21, 22 (22a, 22b, and 22c), and 28, and insulating layers 31, 32, 34, and 38. The memory cell array 110 includes a structure (stacked interconnect 300) in which a plurality of conductive layers 22 (22a, 22b, and 22c) is stacked in a Z direction.

The insulating layer 38 is provided on an upper surface of the semiconductor substrate 20. The insulating layer 38 covers, for example, the CMOS circuit 200 such as the row control circuit 140 and the sense amplifier circuit 150 on the semiconductor substrate 20.

The conductive layer 21 is provided on an upper surface of the insulating layer 38. The conductive layer 21 is, for example, a plate-shaped layer extending along an X-Y plane. The conductive layer 21 is used as the source line SL. The conductive layer 21 includes, for example, phosphorus-doped silicon.

The insulating layer 31 is provided on an upper surface of the conductive layer 21. The conductive layer 22a is provided on an upper surface of the insulating layer 31. The conductive layer 22a is, for example, a plate-shaped layer extending along the X-Y plane. The conductive layer 22a is used as the select gate line SGS. The conductive layer 22a includes, for example, tungsten.

The insulating layer 32 and the conductive layer 22b are alternately stacked in the Z direction on an upper surface of the conductive layer 22a. The conductive layer 22b is, for example, a plate-shaped layer extending along the X-Y plane. A plurality of stacked conductive layers 22b is used as the word lines WL0, ..., and WLn-1 in this order from a semiconductor substrate 20 side. The conductive layer 22b includes, for example, tungsten.

The conductive layer 22c is provided above an uppermost conductive layer 22b via the insulating layer 32. The conductive layer 22c is, for example, a plate-shaped layer extending along the X-Y plane. The conductive layer 22c is used as the select gate line SGD. The conductive layer 22c includes, for example, tungsten.

The insulating layer 34 is provided on an upper surface of the conductive layer 22c. The insulating layer 34 may include a plurality of insulating layers. The conductive layer 28 is provided on an upper surface of the insulating layer 34. The conductive layer 28 is, for example, a line-shaped layer extending in an Y direction. The conductive layer 28 is used as the bit line BL. In a region not illustrated, a plurality of conductive layers 28 is arrayed in an X direction. The conductive layer 28 includes, for example, copper.

Hereinafter, a structure including a plurality of stacked conductive layers 22 and a plurality of insulating layers 31 and 32 is referred to as the stacked interconnect 300.

Each of memory pillars MP is provided in the stacked interconnect 300 so as to extend in the Z direction. The memory pillar MP penetrates the insulating layers 32 and the conductive layers 22. A bottom portion of the memory pillar MP is in contact with the conductive layer 21. A portion where the memory pillar MP and the conductive layer 22a intersect each other functions as the select transistor ST2. A portion where the memory pillar MP and one conductive layer 22b intersect each other functions as one memory cell MT. A portion where the memory pillar MP and the conductive layer 22c intersect each other functions as the select transistor ST1.

Each of the memory pillars MP includes, for example, a core member 24, a semiconductor layer 25, and a stacked film (also referred to as a memory layer) 26. The core member 24 is provided so as to extend in the Z direction. For example, an upper end of the core member 24 is located above the conductive layer 22c. A lower end of the core member 24 reaches the conductive layer 21. The semiconductor layer 25 covers a periphery of the core member 24. In a lower portion of the memory pillar MP, a part of the semiconductor layer 25 is in contact with the conductive layer 21. The stacked film 26 covers a side surface and a bottom surface of the semiconductor layer 25 except for a portion where the semiconductor layer 25 and the conductive layer 21 are in contact with each other. The core member 24 includes, for example, an insulator such as silicon oxide. The semiconductor layer 25 includes, for example, silicon.

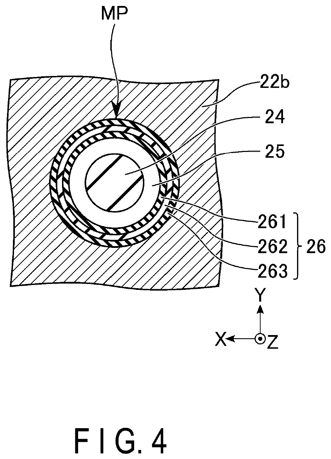

FIG. 4 is a top view illustrating a structure example of the memory pillar of the NAND flash memory.

FIG. 4 is a cross-sectional view for describing a configuration of the memory pillar MP. FIG. 4 illustrates a cross section along the X-Y plane of the memory pillar MP at a position where the conductive layer 22b is arranged.

For example, the memory pillar MP has a circular (or elliptical) planar shape as seen in the Z direction. The semiconductor layer 25 covers a side surface of a cylindrical core member 24. The stacked film 26 is provided between the semiconductor layer 25 and the conductive layer 22b.

The stacked film 26 includes a tunnel insulating layer 261, a charge storage layer 262, and a block insulating layer 263. The tunnel insulating layer 261, the charge storage layer 262, and the block insulating layer 263 are stacked in a direction parallel to a surface (X-Y plane) of the semiconductor substrate 20.

The tunnel insulating layer 261 is provided between the semiconductor layer 25 and the charge storage layer 262. The tunnel insulating layer 261 is a tunnel barrier between the semiconductor layer 25 and the charge storage layer 262. In a case where a voltage of certain magnitude is applied between the conductive layer 22b and the semiconductor layer 25, a charge moves between the semiconductor layer 25 and the charge storage layer 262 due to a tunnel phenomenon. The tunnel insulating layer 261 includes, for example, silicon oxide.

The charge storage layer 262 is provided between the tunnel insulating layer 261 and the block insulating layer 263. For example, the charge storage layer 262 is a charge trap film capable of holding (capturing) the charge. In this case, the charge storage layer 262 includes silicon nitride. Note that, the charge storage layer 262 may be a floating gate electrode. The floating gate electrode includes silicon.

The block insulating layer 263 is provided between the charge storage layer 262 and the conductive layer 22b. The block insulating layer 263 prevents movement of the charge between the charge storage layer 262 and the conductive layer 22b. The block insulating layer 263 includes, for example, silicon oxide, and (or) aluminum oxide.

In the memory pillar MP, the semiconductor layer 25 is used as a channel region (current path) of the memory cells MT0, ..., and MTn-1 and the select transistors ST1 and ST2. The memory device 1 can cause a current to flow between the bit line BL and a contact LI (source line SL) via the memory pillar MP by turning on the memory cells MT0, ..., and MTn-1 and the select transistors ST1 and ST2.

Returning to FIG. 3, a columnar contact CV is provided on an upper surface of the semiconductor layer 25 in the memory pillar MP. In the illustrated region, two contacts CV corresponding to the two memory pillars MP, respectively, out of the six memory pillars MP are illustrated. The contact CV is connected to the memory pillar MP, which does not overlap a slit SHE and to which the contact CV is not connected, in a region not illustrated (for example, a region in a depth direction or a front direction of the paper surface).

One conductive layer 28 (one bit line BL) is in contact with an upper surface of the contact CV. One contact CV is connected to one conductive layer 28 in each of spaces divided by slits SLT and SHE. The memory pillar MP provided between the adjacent slits SLT and SHE and the memory pillar MP provided between the two adjacent slits SHE are electrically connected to each of the conductive layers 28.

The slit SLT includes, for example, a portion provided along an X-Z plane. The slit SLT divides the conductive layer 22. The contact LI in the slit SLT is provided along the slit SLT. A part of an upper end of the contact LI is in contact with the insulating layer 34. A lower end of the contact LI is in contact with the conductive layer 21. The contact LI is used, for example, as a part of the source line SL. A spacer SP is provided at least between the contact LI and the conductive layers 22a, 22b, and 22c. The contact LI is separated and insulated from the conductive layers 22a, 22b, and 22c by the spacer SP.

The slit SHE includes, for example, a portion provided along the X-Z plane. The slit SHE divides at least the conductive layer 22c. An upper end of the slit SHE is in contact with the insulating layer 34. A lower end of the slit SHE is in contact with the insulating layer 32 between the uppermost conductive layer 22b and the conductive layer 22c. The slit SHE includes, for example, an insulator such as silicon oxide. The upper end of the slit SHE and the upper end of the slit SLT may be aligned or not. The upper end of the slit SHE and the upper end of the memory pillar MP may be aligned or not.

A plurality of elements TR and RES may be provided on the semiconductor substrate 20 below the memory cell array 110.

For example, a field-effect transistor TR is provided in a well region 27 of the semiconductor substrate 20. The well region 27 is a semiconductor region partitioned by an insulator 29a having a shallow trench isolation (STI) structure.

The field-effect transistor includes two sources/drains 41 (41a and 41b), a gate insulating film 42, and a gate electrode 43.

The sources/drains 41a and 41b are provided in the well region 27. Each of the sources/drains 41a and 41b is a diffusion layer (impurity semiconductor region). The gate insulating film 42 is provided on the well region 27 between the two sources/drains 41a and 41b. The gate electrode 43 is provided on the gate insulating film 42. A portion in the well region 27 facing the gate electrode 43 is a channel region of the field-effect transistor TR. For example, the gate electrode 43 includes a single layer of polysilicon or a stack of polysilicon and silicide such as nickel silicide (NiSi), nickel platinum silicide (NiPtSi), and cobalt silicide (CoSi). For example, the gate electrode 43 includes a stack of silicon nitride (SiN) and polysilicon, tungsten (W), and tungsten silicide (WSi). For example, the gate electrode 43 includes aluminum (Al), titanium (Ti), and tantalum (Ta). For example, the gate electrode 43 includes a stack of aluminum oxide (AlO), aluminum cobalt copper (AlCoCu), aluminum titanium nitride (AlTiN), aluminum titanium nitride (AlTiN), aluminum titanium oxynitride (AlTiON), tantalum nitride (TaN), and titanium nitride (TiN). For example, the gate electrode 43 includes a stack of silicide such as nickel silicide (NiSi), nickel platinum silicide (NiPtSi), and cobalt silicide (CoSi), polysilicon, and titanium nitride (TiN). For example, the gate electrode 43 includes a stack of tungsten (W), tungsten silicon nitride (WSiN), tungsten (W), titanium nitride (TiN), polysilicon, and titanium nitride (TiN). Note that, the stack herein described does not necessarily include all the layers but may include only some of the layers.

A contact 46a is provided on the gate electrode 43. A contact 46b is provided on the source/drain 41. Each of a plurality of contacts 46a and 46b is electrically connected to each of a plurality of interconnects (metal layers) 47a and 47b in the insulating layer (interlayer insulating film) 38.

For example, a resistor (resistance element) RES is provided on an insulator 29b in the semiconductor substrate 20. The resistor RES includes a conductive layer (resistor layer) 45. The conductive layer 45 has a stacked structure similar to that of the gate electrode 43. For example, the conductive layer 45 includes a single layer of polysilicon or a stack of polysilicon and silicide such as nickel silicide (NiSi), nickel platinum silicide (NiPtSi), and cobalt silicide (CoSi). For example, the conductive layer 45 includes a stack of silicon nitride (SiN) and polysilicon, tungsten (W), and tungsten silicide (WSi). For example, the conductive layer 45 includes aluminum (Al), titanium (Ti), and/or tantalum (Ta). For example, the conductive layer 45 includes a stack of aluminum oxide (AlO), aluminum cobalt copper (AlCoCu), aluminum titanium nitride (AlTiN), aluminum titanium nitride (AlTiN), aluminum titanium oxynitride (AlTiON), tantalum nitride (TaN), and titanium nitride (TiN). For example, the conductive layer 45 includes a stack of silicide such as nickel silicide (NiSi), nickel platinum silicide (NiPtSi), and cobalt silicide (CoSi), polysilicon, and titanium nitride (TiN). For example, the conductive layer 45 includes a stack of tungsten (W), tungsten silicon nitride (WSiN), tungsten (W), titanium nitride (TiN), polysilicon, and titanium nitride (TiN). Note that, the stack herein described does not necessarily include all the layers but may include only some of the layers.

A contact 46c is provided on an upper surface of the conductive layer 45. A contact 46c is connected to an interconnect 47c in the insulating layer 38.

The resistor RES may be provided on a semiconductor region of the semiconductor substrate 20.

The resistor RES may be formed using a metal layer in the insulating layer 38.

The field-effect transistor TR and the resistor RES are electrically connected to other elements on the semiconductor substrate 20 via the interconnects 47a, 47b, and 47c, respectively. As a result, the CMOS circuit 200 such as the row control circuit 140 and the voltage generation circuit 160 is formed on the semiconductor substrate 20 below the memory cell array 110.

Note that, the structure of the memory device 1 of the present embodiment is not limited to the structures in FIGS. 3 and 4. For example, the memory cell array 110 and the CMOS circuit 200 may be formed on different chips (semiconductor substrates). In this case, the chip of the memory cell array 110 is stacked on the chip of the CMOS circuit 200 in the Z direction. The chip of the memory cell array 110 is bonded to the chip of the CMOS circuit 200 via a conductive member.

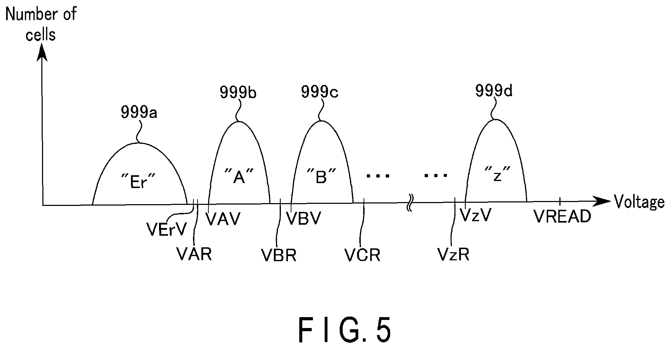

FIG. 5 is a graph for describing a relationship between data stored in the memory cell MT and a threshold voltage of the memory cell MT.

As illustrated in FIG. 5, the memory cell MT can take a plurality of states according to the threshold voltage. The plurality of memory cells includes variations in characteristics. In consideration of the variations in characteristics, data is associated with a voltage value distribution (hereinafter, referred to as a threshold voltage distribution) 999 (999a, 999b, 999c, and 999d) centered on a voltage value of a certain threshold voltage.

The memory cell MT can take an erase state and one or more program states.

In FIG. 5, an "Er" state corresponds to the erase state (a state in which data is erased), and "A", "B", ..., and "z" states correspond to the program states (states in which data is programmed). Note that, the "z" state conveniently indicates the program state corresponding to the highest threshold voltage (threshold voltage distribution) out of a plurality of program states that can be taken by the memory cell MT.

A single level cell (SLC) is 1 bit/cell, and can take two states ("Er" and "A" states). A multi level cell (MLC) is 2 bit/cell, and can take four states ("Er", "A", "B", and "C" states). A triple level cell (TLC) is 3 bit/cell, and can take eight states ("Er", "A", "B", ..., "F", and "G" states). A quad level cell (QLC) is 4 bit/cell, and can take 16 states ("0", "1", "2", ..., "E", and "F" states). A penta level cell (PLC) is 5 bit/cell, and can take 32 states ("0", "1", "2", ..., "U", and "V" states). A hexa level cell (HLC) is 6 bit/cell, and can take 64 states ("0", "1", "2", ..., "BA", and "BB" states). A seven level cell (7LC) is 7 bit/cell, and can take 128 states ("0", "1", "2", ..., "DM", and "DN" states).

In an example in FIG. 5, the threshold voltage distribution 999a of the memory cell MT in the "Er" state is less than a voltage VAR. The threshold voltage distribution 999b of the memory cell MT in the "A" state is not less than the voltage VAR and is less than a voltage VBR (>VAR). The threshold voltage distribution 999c of the memory cell MT in the "B" state is not less than the voltage VBR and is less than a voltage VCR (>VBR). The threshold voltage distribution 999d of the memory cell MT in the "z" state is not less than a voltage VzR and is less than a voltage VREAD.

Each of the voltages (voltage values) VAR, VBR, ..., and VzR is a voltage used for data read. Hereinafter, each of the voltages VAR, VBR, ..., and VzR is also referred to as a determination level or a read level. The voltages VAR to VzR are also collectively referred to as a voltage (read voltage) VCGR. The voltage VREAD is, for example, a voltage applied to a word line (non-selected word line) WL that does not include a read target at the time of a read operation. In a case where the voltage VREAD is applied to the memory cell MT, the memory cell MT is turned on regardless of the data stored in the memory cell MT. The data stored in the memory cell MT is determined based on an on/off result of the memory cell MT regarding the applied read level.

For verification of data write, voltages VAV, VBV, ..., and VzV are provided for each state. The voltage VAV is higher than the read level VAR and not higher than a lower limit value of a desired threshold voltage distribution 999b of the "A" state. The voltage VBV is higher than the read level VBR and not higher than a lower limit value of a desired threshold voltage distribution 999c of the "B" state. The voltage VzV is higher than the read level VzR and not higher than a lower limit value of a desired threshold voltage distribution 999d of the "z" state.

For verification of erase of data, a voltage VErV is provided between the threshold voltage distribution 999a of the "Er" state and the threshold voltage distribution 999b of the "A" state. For example, the voltage VErV is lower than the voltage VAR and is not lower than an upper limit of the desired threshold voltage distribution 999a of the "Er" state.

Hereinafter, each of the voltages VErV, VAV, VBV, ..., and VzV is also referred to as a verify level.

Regarding the verification of each state, in a case where the verify level is applied to the memory cell MT, it is determined whether or not the verification of the state of each memory cell MT regarding the write of data or the erase of data is pass (whether or not this is fail) according to whether or not the memory cell MT is turned on. Depending on whether the number of passes/fails of the verification of the states of the plurality of memory cells is a value within an acceptable range, it is verified whether the executed operation sequence is successful.

The characteristics of the memory cell MT fluctuate according to the temperature of the chip (package). Therefore, it is desirable that the voltage value of each read level and the voltage value of each verify level be adjusted according to the temperature of the chip.

As illustrated in FIG. 1 described above, the memory device (semiconductor device) 1 of the present embodiment includes the digital-analog conversion circuit 163 in the voltage generation circuit 160.

Hereinafter, the digital-analog conversion circuit 163 is referred to as a DA conversion circuit 163.

The DA conversion circuit 163 receives the code CD. The DA conversion circuit 163 operates based on the code CD.

The driver circuit 162 outputs various voltages used for the operation of the memory cell array 110 to the row control circuit 140 and the sense amplifier circuit 150 using the voltage boosted by the charge pump circuit 161.

The driver circuit 162 outputs various adjusted voltages to each of the interconnect connected to the word line WL, the interconnects connected to the select gate lines SGD and SGS, and the interconnect connected to the source line SL according to a conversion result of the code CD by the DA conversion circuit 163. For example, when the value of the code CD increases, an output voltage of the driver circuit 162 increases.

In this manner, in the present embodiment, magnitude of the output voltage of the driver circuit 162 is controlled by the DA conversion circuit 163 based on the code CD.

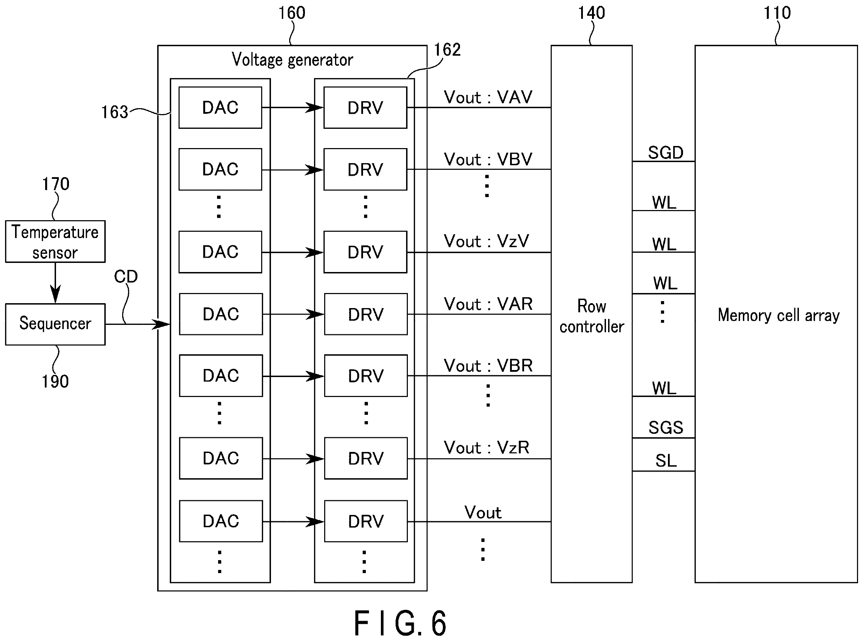

FIG. 6 is a circuit diagram illustrating a configuration example of the driver circuit 162 and the DA conversion circuit 163 in the voltage generation circuit 160 in the memory device 1 of the present embodiment.

The driver circuit 162 includes a plurality of drivers DRV.

The DA conversion circuit 163 includes a plurality of DA converters DAC.

One DA converter DAC is connected to one driver DRV. A set of one DA converter DAC and one driver DRV might be regarded as one circuit unit (DA converter or driver) in some cases.

Each DA converter DAC receives the code CD from the sequencer 190. As described above, the code CD is the digital signal (digital value) generated based on the measurement result of the temperature by the temperature sensor 170.

The DA converter DAC supplies an analog signal (for example, voltage and/or current) based on the code CD to the driver DRV.

The driver DRV supplies an output voltage Vout having magnitude corresponding to the analog signal from the DA converter DAC to the memory cell array 110 via the row control circuit 140. The output voltage Vout is supplied to the word line WL, the select gate lines SGD and SGS, or the source line SL.

The output voltage Vout of the driver DRV is, for example, the verify level (verify voltage) used for the write sequence or the read level (read voltage) used for the read sequence.

The output voltage Vout of the driver DRV might include a program voltage, a non-selected voltage VREAD, voltages supplied to the select gate lines SGD and SGS or the like.

In this manner, magnitude of the output voltage Vout of the driver DRV is controlled based on a result of DA conversion processing of the DA converter DAC.

Note that, the output signal Vout of the driver DRV may be supplied to the sense amplifier circuit 150.

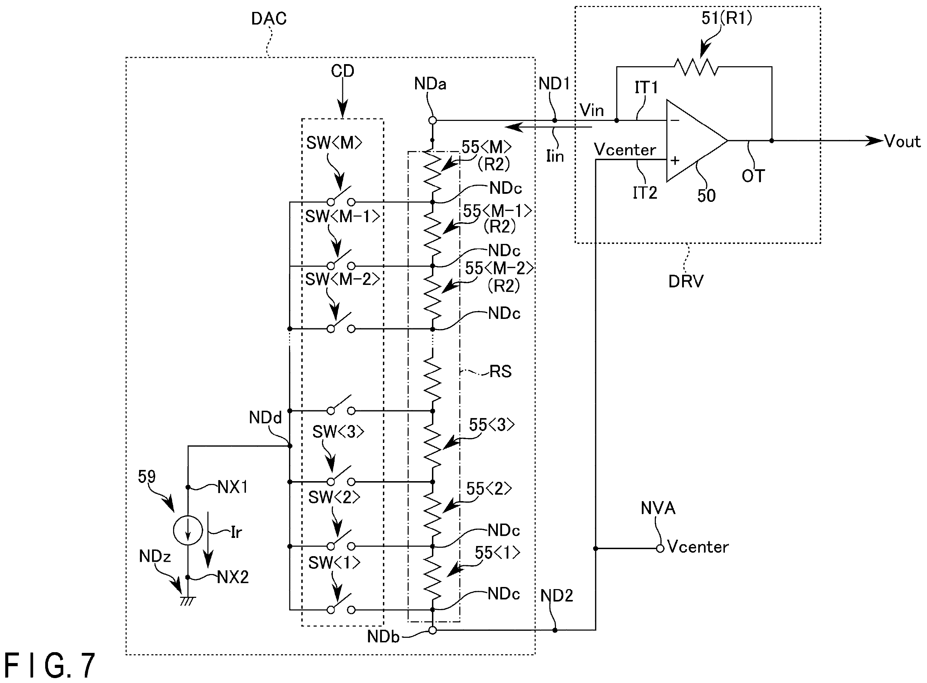

FIG. 7 is a circuit diagram illustrating an internal configuration of the driver circuit 162 and the DA conversion circuit 163 in the memory device (semiconductor device) 1 of the present embodiment.

In the driver circuit 162, the driver DRV includes an operational amplifier 50 and a resistor 51.

The operational amplifier 50 includes two input terminals IT1 and IT2 and one output terminal OT. One input terminal IT1 is an inverting input terminal. The inverting input terminal IT1 is connected to a node ND1. The other input terminal IT2 is a non-inverting input terminal. The non-inverting input terminal IT2 is connected to a node ND2.

The output terminal OT is an output node of the driver DRV. The output terminal OT is electrically connected to, for example, the interconnect connected to the word line WL, the interconnect connected to the select gate line SGD, the interconnect connected to the select gate line SGS, or the interconnect connected to the source line SL.

A voltage Vin of the node ND1 is supplied to the inverting input terminal IT1. Magnitude of the voltage Vin is controlled to be the same magnitude as the voltage (for example, a voltage Vcenter) of the non-inverting input terminal IT2 by an operational amplification operation of the operational amplifier 50. As a result, the current Iin flows through the inverting input terminal IT1 and the node ND1. The voltage Vin does not depend on a resistance value of the resistor 51 and a current value of the current Iin.

For example, potential of the node ND2 is set to the voltage Vcenter having a certain voltage value by the voltage generation circuit 160. For example, the voltage Vcenter is applied to the node ND2 via a voltage node NVA. As a result, the voltage Vcenter is supplied from the node ND2 to the non-inverting input terminal IT2.

The resistor 51 is connected to the operational amplifier 50. One end of the resistor 51 is connected to the inverting input terminal IT1 of the operational amplifier 50. The other end of the resistor 51 is connected to the output terminal OT of the operational amplifier 50. The resistor 51 has a resistance value R1. For example, the resistor 51 is formed using the resistor RES in FIG. 3.

The operational amplifier 50 and the resistor 51 form an inverting amplifier circuit. Hereinafter, a set (driver) DRV including the operational amplifier 50 and the resistor 51 is also referred to as a driver amplifier DRV.

For example, the operational amplifier 50 forming the inverting amplifier circuit outputs the voltage Vout corresponding to the sum of potential of the input terminal IT1 and potential of the input terminal IT2 from the output terminal OT.

The DA converter DAC includes a resistor string (also referred to as a resistor network or a resistor circuit) RS, a plurality of switches SW, and a current source circuit 59.

One end (input node) NDa of the resistor string RS is connected to the inverting input terminal IT1 of the operational amplifier 50 via the node ND1.

The other end (output node) NDb of the resistor string RS is connected to the non-inverting input terminal IT2 of the operational amplifier 50 via the node ND2.

The resistor string RS includes a plurality of resistors 55 connected in series. For example, the resistor string RS includes M resistors 55. M is a natural number not smaller than 1. The resistance value of each resistor 55 is the same. Each resistor 55 has a resistance value R2. For example, the resistor 55 is formed using the resistor RES in FIG. 3. The resistance value R2 of the resistor 55 can take, for example, a certain value in a range of 10 Ω to 10 kΩ. A more specific example of the resistance value R2 is 1 kΩ.

A plurality of switches SW (SW<1>, SW<2>, ..., SW<M-1>, and SW<M>) is connected to the resistor string RS. The number of switches SW is M. One switch SW is associated with one resistor 55.

Each switch SW is connected to a connection node NDc between the two resistors 55.

In each of the plurality of switches SW, one end of the switch SW is connected to the corresponding connection node NDc. The other end of each switch SW is connected to a node NDd. Hereinafter, the connection node NDc is also referred to as a tap.

Between the resistor string RS and the node NDd, the plurality of switches SW is connected in parallel to each other.

For example, the switch SW is a metal-oxide-semiconductor (MOS) switch or a field-effect transistor.

An input node NX1 of the current source circuit 59 is connected to the node NDd. A node NX2 of the current source circuit 59 is connected to a ground node NDz.

The current source circuit 59 draws a part of the current (current Ir) flowing through the resistor string RS via one switch SW in an on state. The current source circuit 59 causes the current Ir to flow from the node NDc to which the switch SW in the on state is connected to the ground node NDz. Magnitude of the current Ir can be determined according to a driving force of the current source circuit 59.

In the DA converter DAC, one digital value indicated by the code CD is allocated to each of the plurality of switches SW.

The number of bits of the code CD depends on the number of resistors 55 in the resistor string RS. For example, in a case where the number of resistors 55 in the resistor string RS is 256, the number of bits of the code CD is eight.

Note that, the number of resistors 55 is not limited to 256. The number of resistors 55 may be 512 (= $2^9$) or 1024 (= $2^{10}$) or larger. In this case, the number of bits of the code CD is nine or ten or larger. The number of resistors 55 may be 128 (= $2^7$) or smaller. In this case, the number of bits of the code CD is seven or smaller.

Different 8-bit codes are allocated to the switches SW, respectively, in such a manner that one switch SW can be specified out of the plurality of switches SW. One switch SW is activated by one 8-bit digital value of the code CD.

At the time of operation of the DA converter DAC, any one of the plurality of switches SW is turned on based on the supplied code CD. Out of the plurality of switches SW, the remaining switches SW are turned off.

For example, the digital value of the code CD is allocated to each of the plurality of switches SW in such a manner that the digital value of the code CD increases in the order from a node NDb side of the resistor string RS (a non-inverting input terminal IT2 side of the operational amplifier 50) toward a node NDa side of the resistor string RS (an inverting input terminal IT1 side of the operational amplifier 50).

Out of the plurality of switches SW, the code CD of a first digital value is allocated to the switch SW<1> the closest to the node NDb. Out of the plurality of switches SW, the code CD of a last digital value is allocated to the switch SW<M> the closest to the node NDa.

For example, in a case where the digital code CD is indicated by the 8-bit digital value, the switch SW<1> at a first stage has a first code (for example, "00000000") CD. In a case where the digital code CD is indicated by the 8-bit digital value, the switch SW<M(M=256)> at a last (256th) stage has a 256th code (for example, "11111111") CD.

Regarding a current path between the inverting input terminal IT and the current source circuit 59, the number of resistors 55 to be in an effective state on the current path changes according to the value of the code CD.

In a case where the value of the code CD is small, the number of resistors 55 to be in the effective state on the current path between the inverting input terminal IT1 and the current source circuit 59 (current path from the node NDa to the node NDc) is large. In contrast, in a case where the value of the code CD is large, the number of resistors 55 to be in the effective state on the current path between the inverting input terminal IT1 and the current source circuit 59 is smaller than that in a case where the value of the code CD is small.

As a result, the current Iin flowing through the inverting input terminal IT1 of the operational amplifier 50 increases as the value of the digital value of the code CD increases.

In this manner, in the DA conversion circuit 163 of the memory device 1 of the present embodiment, a converted value from the digital value (code CD) to the analog value (current Iin) in the DA converter DAC changes relatively monotonically.

The current source circuit 59 is electrically connected to one connection node NDc in the resistor string RS via one switch SW in the on state.

For example, it depends on the temperature of the memory device 1 which of the plurality of switches SW is selectively turned on.

<Current Source Circuit>

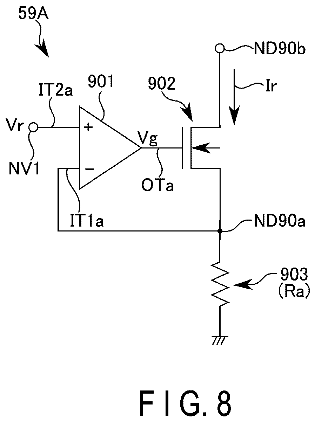

A configuration example of the current source circuit 59 in the DA conversion circuit 163 of the memory device 1 of the present embodiment will be described with reference to FIGS. 8, 9, and 10.

FIG. 8 is a circuit diagram illustrating an example of a current source circuit 59A used in the DA converter DAC.

The current source circuit 59A is a current source having a circuit configuration (OP-amp+Tr type) including an operational amplifier and a field-effect transistor. The OP-amp+TR type current source circuit 59A can relatively stabilize a change in current even when the output voltage changes.

The current source circuit 59A includes an operational amplifier 901, a field-effect transistor 902, and a resistor 903.

The operational amplifier 901 includes an inverting input terminal IT1a, a non-inverting input terminal IT2a, and an output terminal OTa.

The field-effect transistor 902 includes a gate and two sources/drains (two nodes). For example, the field-effect transistor 902 is an n-channel metal-oxide-semiconductor (MOS) transistor.

Hereinafter, the field-effect transistor is also simply referred to as a transistor.

The inverting input terminal IT1a of the operational amplifier 901 is connected to one end of the resistor 903 via a node ND90a. The non-inverting input terminal IT2a of the operational amplifier 901 is connected to a voltage node NV1 to which a voltage Vr is applied. The output terminal OTa of the operational amplifier 901 is connected to the gate of the field-effect transistor 902.

One source/drain of the field-effect transistor 902 is connected to a node ND90b. The other source/drain of the field-effect transistor 902 is connected to the one end of the resistor 903. The other end of the resistor 903 is connected to a ground node. The resistor 903 has a resistance value Ra.

For example, the node ND90b is connected to the node NDd.

The operational amplifier 901 supplies an output voltage Vg to the gate of the field-effect transistor 902 based on operation processing using the voltage Vr and potential of the node ND90a.

The field-effect transistor 902 causes the current Ir to flow by a driving force corresponding to the output voltage Vg of the operational amplifier 901.

The magnitude of the current Ir in the current source circuit 59A in FIG. 8 has the following relationship.

$$Ir = Vr/Ra$$

The current source circuit 59A can cause a current of one polarity to flow.

In this manner, the current source circuit 59A in FIG. 8 functions as a current source.

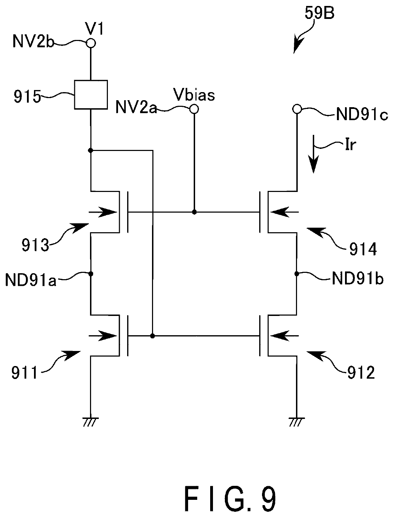

FIG. 9 is a circuit diagram illustrating an example of a current source circuit 59B different from that in FIG. 8.

As illustrated in FIG. 9, the current source circuit 59B includes four field-effect transistors 911, 912, 913, 914 and a current source element 915.

The current source circuit 59B is a current mirror type current source. The current mirror type current source circuit 59B has a relatively small circuit scale. The current mirror type current source circuit 59B can relatively easily cope with a low power supply voltage.

The current source circuit 59B is a current mirror circuit having a cascode structure.

Each of the transistors 911, 912, 913, and 914 includes a gate and two sources/drains (two nodes). Each of the transistors 911, 912, 913, and 914 is an n-channel MOS transistor.

The gate of the transistor 911 is connected to the gate of the transistor 912.

One source/drain of the transistor 911 is connected to a ground node. The other source/drain of the transistor 911 is connected to a node ND91a.

One source/drain of the transistor 912 is connected to the ground node. The other source/drain of the transistor 912 is connected to a node ND91b.

The gate of the transistor 913 is connected to the gate of the transistor 914.

One source/drain of the transistor 913 is connected to the other source/drain of the transistor 911 via the node ND91a.

One source/drain of the transistor 914 is connected to the other source/drain of the transistor 912 via the node ND91b.

The other source/drain of the transistor 913 is connected to the gates of the transistors 911 and 912.

The gates of the transistors 913 and 914 are connected to a voltage node NV2a. A bias voltage Vbias is supplied to the gates of the transistors 913 and 914 via the voltage node NV2a.

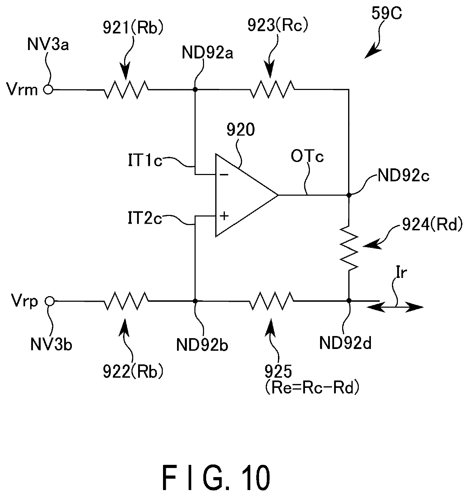

The element 915 is connected between the other source/drain of the transistor 913 and a voltage node NV2b. For example, a voltage V1 such as a power supply voltage or a reference voltage is supplied to the voltage node NV2b. The element 915 includes a resistance element or a current source (for example, the current source circuit in FIG. 8 or FIG. 10 described later).

The other source/drain of the transistor 914 is connected to a node ND91c. The Node ND91c is connected to the node NDd.

The transistors 913 and 914 operate by a driving force corresponding to the bias voltage Vbias.

The transistors 911 and 912 operate according to potential of the other source/drain of the transistor 913.

By the current mirror circuit including the cascode-connected transistors 911, 912, 913, and 914, the current source circuit 59B can cause the current Ir of one polarity to flow.

The circuit 59B in FIG. 9 can form the current source circuit 59 with a relatively small circuit area.

FIG. 10 is a circuit diagram illustrating an example of a current source circuit 59C different from that in FIGS. 8 and 9.

The current source circuit 59C in FIG. 10 is an operational amplification type (OP-amp type) current source. The OP-amp type current source circuit 59C can set the polarity of the current to be output in both negative polarity and positive polarity directions.

The current source circuit 59C includes an operational amplifier 920 and a plurality of resistors 921, 922, 923, 924, and 925.

The operational amplifier 920 includes an inverting input terminal IT1c, a non-inverting input terminal IT2c, and an output terminal OTc. The inverting input terminal IT1c is connected to a node ND92a. The non-inverting input terminal IT2c is connected to a node ND92b. The output terminal OT2 is connected to a node ND92c.

One end of the resistor 921 is connected to the inverting input terminal IT1c via the node ND92a. The other end of the resistor 921 is connected to a voltage node NV3a. A voltage Vrm is supplied to the voltage node NV3a.

One end of the resistor 922 is connected to the non-inverting input terminal IT2c via the node ND92b. The other end of the resistor 922 is connected to a voltage node NV3b. A voltage Vrp is supplied to the voltage node NV3b.

One end of the resistor 923 is connected to the inverting input terminal IT1c via the node ND92a. The other end of the resistor 923 is connected to the output terminal OTc via the node ND92c.

One end of the resistor 924 is connected to the output terminal OTc and the other end of the resistor 923 via the node ND92c. The other end of the resistor 924 is connected to a node ND92d.

One end of the resistor 925 is connected to the other end of the resistor 924 via the node ND92d. The other end of the resistor 925 is connected to the non-inverting input terminal IT2c and the one end of the resistor 922 via the node ND92b.

Each of the resistors 921 and 922 has a resistance value Rb. The resistor 923 has a resistance value Rc. The resistor 924 has a resistance value Rd. The resistor 925 has a resistance value Re. Magnitude of the resistance value Re corresponds to "Rc-Rd".

The current source circuit 59C outputs the current Ir from the node ND92d. For example, the node ND92d is connected to the node NDd.

The magnitude of the current Ir in the current source circuit 59C in FIG. 10 has the following relationship.

$$Ir = (Rc/Rb) \times (Vrp - Vrm)/Rd$$

In this manner, the current source circuit 59C functions as the current source by an arithmetic operation of the operational amplifier 920.

The current source circuit 59 can cause the current Ir to flow at the node ND92d in both positive polarity and negative polarity.

Note that, the circuits 59A, 59B, and 59C in FIGS. 8, 9, and 10 are examples of the current source circuit 59. The current source circuit 59 of the DA converter DAC may have a circuit configuration other than the configurations in FIGS. 8, 9, and 10.

(b) Operation Example

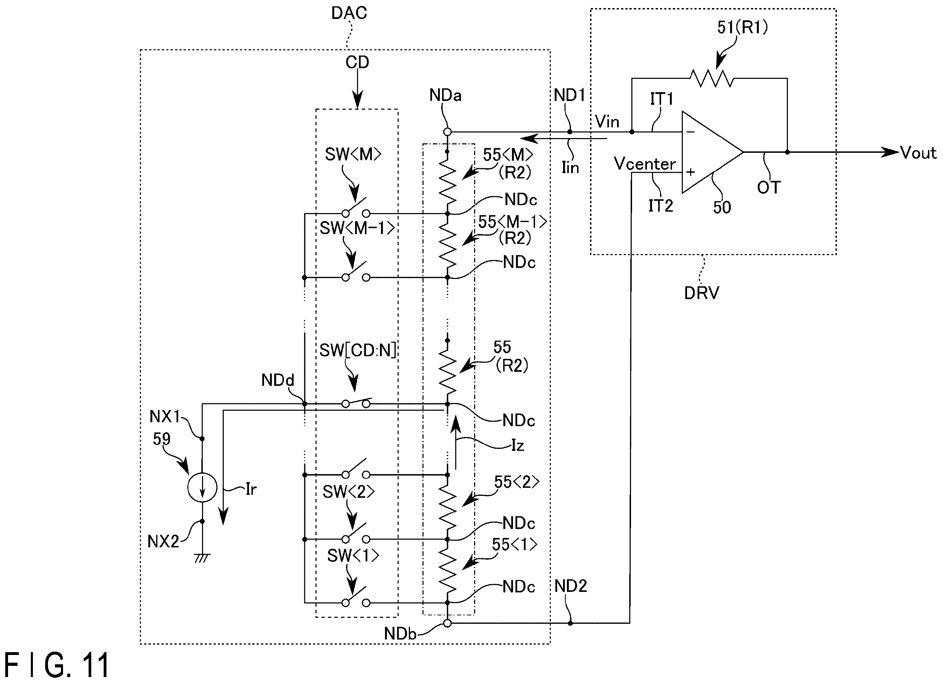

An operation example of the driver circuit 162 and the DA conversion circuit 163 in the semiconductor device 1 of the present embodiment will be described with reference to FIG. 11.

In the memory device (for example, the NAND flash memory) 1 as the semiconductor device of the present embodiment, the driver circuit 162 and the DA conversion circuit 163 operate when supplying voltages to the word line WL, the select gate lines SGD and SGS, and the source line SL in the write sequence and the read sequence.

For example, the DA conversion circuit 163 contributes to adjustment of the voltage values of the verify level and the read level according to the temperature of the memory device 1.

In the memory device 1 of the present embodiment, the temperature sensor 170 senses the temperature of the chip (or the package) at a certain timing. The temperature sensor 170 transmits the measurement result of the temperature to the sequencer 190.

For example, the sequencer 190 receives the measurement result of the temperature sensor 170. In the sequencer 190, the digital control circuit 191 generates the code CD having a digital value corresponding to the measurement result and the command CMD based on the measurement result of the temperature and the command CMD in the command register 120. The sequencer 190 transmits the generated code CD to the voltage generation circuit 160.

The voltage generation circuit 160 receives the code CD. The voltage generation circuit 160 transmits the received code CD to the DA conversion circuit 163.

The DA conversion circuit 163 receives the code CD. In the DA conversion circuit 163, each DA converter DAC controls on and off of the plurality of switches SW based on the code CD. As a result, one switch SW corresponding to the code CD out of the plurality of switches SW is turned on.

In the example in FIG. 11, a switch SW[CD:N] having the code CD of "N" is turned on. N is an integer not smaller than 0. For example, N is M or smaller. For example, a possible maximum value of N is M-1. For example, N also corresponds to the number of resistors 55 present on the current path from the node NDb at the other end of the resistor string RS to a position of the switch SW in the on state.

The node (tap) NDc connected to the switch SW[CD:N] in the on state is electrically connected to the node NDd. As in this example, in a case where the switch SW[CD:N] having the code CD of "N" is in the on state, the M-N resistors 55 are connected to the current source circuit 59 via the switch SW[CD:N] in the on state.

In this manner, the number of resistors 55 put into the effective state as the current path of the current Iin is determined based on the number (address) of the switch SW in the on state indicated by the code CD.

The current source circuit 59 causes the current Ir to flow from the connection node NDc to the ground node NDz via the switch SW[CD:N] in the on state.

Magnitude of the current Iin depends on the number (here, M-N) of resistors 55 through which the current Iin flows.

The current Iin is divided at the connection node NDc to which the switch SW in the on state is connected.

A current Iz, which is the remaining part of the current Iin, flows from the non-inverting input terminal IT2 of the operational amplifier 50 toward the current source circuit 59 via the switch SW[CD:N] in the on state.

A relationship between the current Iin and the current Ir is expressed by following expression 1.

$$Iin = (N/M) \times Ir \quad ... \quad (\text{Expression 1})$$

Here, "M" represents the number of resistors 55 in the resistor string RS. M is a natural number not smaller than 1. "N" represents a value corresponding to the number allocated to the switch SW in the on state. For example, N is a natural number not smaller than 0 (zero). N and M may be binary numbers or decimal numbers.

As an example, in a case where the number (M) of the resistors 55 is 256, "N" has any one value in a range of 0 to 255. Note that, in a case where "N" is 0, the current Iin is 0 from the viewpoint of circuit design. Note that, the current Iin has a weak current value according to an interconnect resistance included in the circuit and/or variation in characteristics between elements forming the circuit.

Note that, the value of "N" can be rephrased as the value indicating the number of resistors 55 present from the node NDb at the other end of the resistor string RS to the position of the switch SW in the on state.

The value of "N" can also be rephrased as a value corresponding to a position where the connection node NDc in the resistor string RS out of the plurality of connection nodes (taps of the resistor 55) NDc in the resistor string RS is connected (short-circuited) to the input node NX1 (or the node NDd) of the current source circuit 59 via the switch SW in the on state.

Alternatively, the value of "N" can also be rephrased as a value indicating the number of resistors 55 that are not present between the switch SW in the on state and the one end (input node) NDa of the resistor string NS out of the plurality of (M) resistors 55 in the resistor string RS.

As in expression 1, the current Iin can be determined without depending on magnitude of the resistance value R1 of the resistor 51 and magnitude of the resistance value R2 of the resistor 55.

The current Iin, which is an analog value of certain magnitude, is obtained by the DA converter DAC according to a digital value N indicated by the code CD.

For example, it is assumed that the number of resistors 55 is 256 and the code CD is an 8-bit digital value. In this case, in a case where a first switch SW<0> is selectively turned on, the magnitude of the current Iin becomes substantially zero. In a case where a 256th switch SW<256> is selectively turned on, the magnitude of the current Iin is about (255/256) × Ir.

The output voltage Vout of the driver DRV is expressed by following expression 2.

$$Vout = Vcenter + R1 \times (N/M) \times Ir \quad ... \quad (\text{Expression 2})$$

Here, "Vcenter" represents a voltage supplied to the non-inverting input terminal IT2 of the operational amplifier 50. "R1" represents a resistance value of the resistor 51.

For example, "Vcenter", "M", and "Ir" in expression 2 are design parameters set for the DA converter DAC and the driver DRV. As described above, "N" in expression 2 is a variable corresponding to the digital code CD based on the temperature of the memory device 1 and the command CMD.

Therefore, in expression 2, the magnitude of the output voltage Vout can be controlled according to the value of "N".

In this manner, the magnitude of the output voltage Vout can be adjusted according to the code CD, which is the digital value.

As described above, in the voltage generation circuit 160 of the memory device 1 of the present embodiment, the DA converter DAC and the driver DRV operate.

As a result, in the present embodiment, the voltage having the adjusted voltage value is supplied to the interconnect in the memory cell array 110.

(c) Summary

In the NAND flash memory, an allowable range of fluctuation of the verify level and the read level with respect to each threshold voltage distribution decreases as the number of bits that can be stored in one memory cell increases.

The characteristics of the memory cell change according to the temperature of the chip.

Therefore, it is desirable that the voltage value of the verify level and the read level be adjusted with higher accuracy.

In the memory device, which is the semiconductor device of the present embodiment, the DA conversion circuit 163 is used to control the magnitude of the voltage Vout output by the driver circuit 162.

In the DA conversion circuit 163, the DA converter DAC includes the resistor string RS and the plurality of switches SW. The resistor string RS includes the plurality of resistors 55 connected in series. Each of the plurality of switches SW is connected to one end of one corresponding resistor 55. The resistor string RS is electrically connected to the current source circuit 59 via the plurality of switches SW.

When outputting the voltage Vout from each driver DRV in the driver circuit 162, one of the plurality of switches SW of each DA converter DAC is set to the on state based on the digital value of the code CD. As a result, the number of resistors 55 through which the current from the driver DRV flows in the resistor string RS is controlled. The magnitude of the current flowing in the resistor string RS is determined.

As a result, in the memory device 1 as the semiconductor device of the present embodiment, monotonicity of DA conversion of the DA converter DAC is guaranteed.

For example, in a case where a DA converter of a certain semiconductor device has a circuit configuration that uses a divided voltage of the voltage by the resistor string with respect to an output voltage of a voltage source, output impedance at the output node of the resistor string changes according to the digital code. As a result, in a circuit in which the DA converter that uses a resistance divided voltage of the voltage and the inverting amplifier circuit are combined, integral nonlinearity (INL) is deteriorated.

As in the semiconductor device of the present embodiment, in a case where the DA converter DAC has a circuit configuration that uses a division of the current by the resistor string with respect to the output of the current source circuit 59, it is possible to substantially eliminate the change in output impedance at the output node of the resistor string RS.

As a result, in the circuit in which the DA converter DAC in the present embodiment and the inverting amplifier circuit (driver) DRV are combined, the INL is not deteriorated.

In a manufacturing process, even if the resistance values R2 of the plurality of resistors 55 in the DA converter 205 vary, there is little influence on the current Iin and the output voltage Vout. Therefore, in the semiconductor device 1 of the present embodiment, even if resolution of the DA converter DAC is, for example, a high bit of 8 bits or higher, the accuracy such as differential non-linearity (DNL) of the resistor string RS and the DA conversion circuit 163 is easily maintained high.

Note that, the resistance value R2 of the resistor 55 may be any value because the output voltage Vout of the driver DRV increases according to the value of the code. Therefore, the resistor 55 may have a resistance value that is easy to manufacture according to a manufacturing method or the like. That is, the resistance value R2 of the resistor 55 may be small. Therefore, the semiconductor device 1 of the present embodiment can implement the resistor string RS and the DA conversion circuit 163 having a small area.

As represented by expressions 1 and 2 above, the current Iin and the output voltage Vout do not depend on the resistance value R2 of the resistor 55 in the resistor string RS.

Therefore, the resistance value R2 of the resistor 55 can be set independently of the resistance value R1 of the resistor 51 used for the driver (inverting amplifier circuit) DRV. As a result, the semiconductor device 1 of the present embodiment can improve a degree of freedom in design of the resistor string RS and the DA conversion circuit 163.

In the semiconductor device 1 of the present embodiment, the operational amplifier 50 of the driver DRV outputs the output voltage Vout by an inverting amplification operation. Therefore, it is not necessary to supply a wide range of input voltages to the operational amplifier 50. As a result, in the semiconductor device 1 of the present embodiment, the driver DRV is suitable for operation with a low power supply voltage.

As described above, the semiconductor device of the present embodiment can improve the characteristics of the device.

(2) Second Embodiment

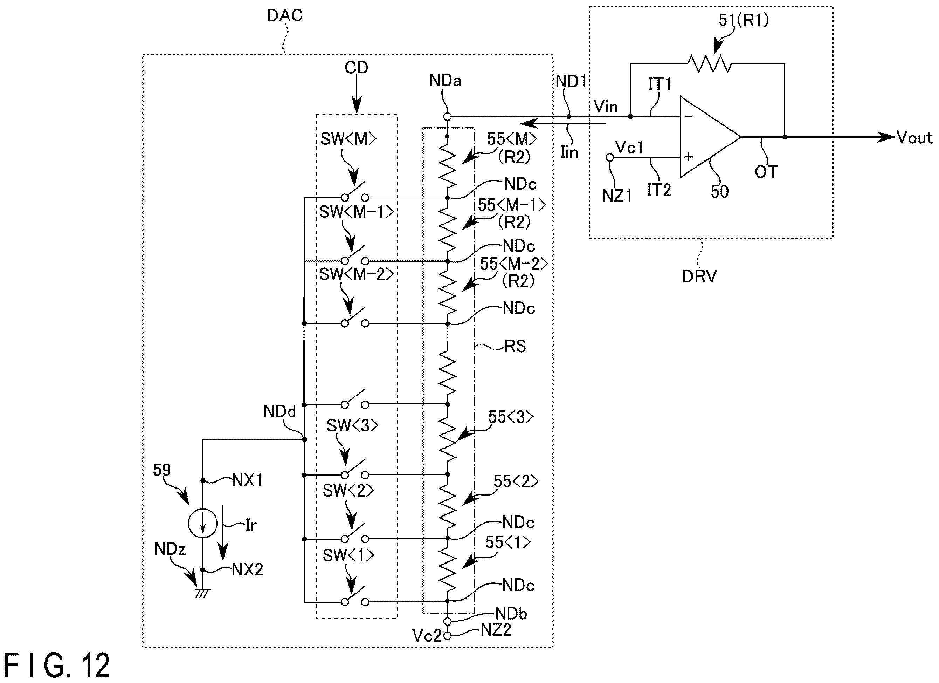

A semiconductor device of a second embodiment will be described with reference to FIG. 12.

FIG. 12 is a diagram illustrating a configuration example of a DA converter DAC in a semiconductor device (for example, a memory device) 1 of the present embodiment.

As illustrated in FIG. 12, in the present embodiment, a non-inverting input terminal IT2 of an operational amplifier 50 is separated from a resistor string RS.

The non-inverting input terminal IT2 of the operational amplifier 50 is connected to a voltage node NZ1. A voltage generation circuit 160 applies a voltage Vc1 to the voltage node NZ1. As a result, the voltage Vc1 is supplied to the non-inverting input terminal IT2 of the operational amplifier 50.

A node NDb of the resistor string RS is connected to a voltage node NZ2. The voltage generation circuit 160 applies a voltage Vc2 to the voltage node NZ2.

As a result, the voltage Vc2 is supplied to the node NDb of the resistor string RS.

Each of the voltage Vc1 and the voltage Vc2 is a fixed voltage having a certain voltage value.

Magnitude of the output voltage Vout of the driver DRV can be changed by controlling a magnitude relationship between the voltages Vc1 and Vc2.

For example, in a case where the voltage value of the voltage Vc2 is made smaller than the voltage value of the voltage Vc1, a voltage value of the output voltage Vout increases.

In contrast, in a case where the voltage value of the voltage Vc2 is made larger than the voltage value of the voltage Vc1, the voltage value of the output voltage Vout decreases.

In the present embodiment, a current Iin is expressed by following expression 3.

$$\text{Iin} = (N/M) \times \text{Ir} + (Vc1 - Vc2)/(M \times R2) \dots \text{(Expression 3)}$$

Here, "Vc1" represents the voltage value of the voltage Vc1 supplied to the non-inverting input terminal IT2 of the operational amplifier 50. "Vc2" represents the voltage value of the voltage Vc2 supplied to the other end of the resistor string RS.

The output voltage Vout of the driver DRV is expressed by following expression 4.

Vout = Vc1 + R1 × (N/M) × Ir + (R1/R2) × (Vc1 - Vc2)/M ... (Expression 4)　　　　　(Expression 4)

In this manner, the magnitude of the output voltage Vout changes according to the voltages Vc1 and Vc2 in addition to values of "N" and "M" determined by the DA converter DAC.

With the above configuration, in the present embodiment, monotonicity of DA conversion in the DA converter DAC is guaranteed.

In the present embodiment, rise and fall of the output voltage Vout of the driver DRV can be controlled.

As described above, the semiconductor device of the present embodiment can improve the characteristics of the semiconductor device as in the first embodiment.


(3) Third Embodiment

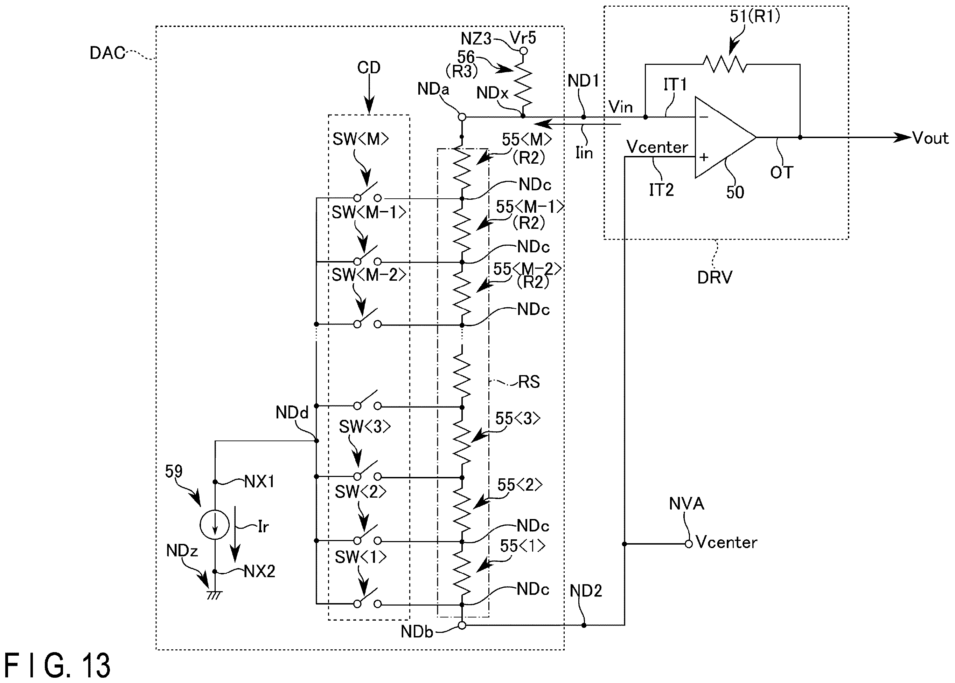

A semiconductor device of a third embodiment will be described with reference to FIG. 13.

FIG. 13 is a diagram illustrating a configuration example of a DA converter DAC in a DA conversion circuit in a semiconductor device (for example, a memory device) 1 of the present embodiment.

As illustrated in FIG. 13, a resistor 56 is connected to a node NDx provided between a driver DRV and the DA converter DAC.

The node NDx is connected to an inverting input terminal IT1 of an operational amplifier 50, a node NDa at one end of a resistor string RS, and one end of a resistor 51.

One end of the resistor 56 is connected to the node NDx. The other end of the resistor 56 is connected to a voltage node NZ3. The node NDx is provided between a node ND1 and a node NDa.

A voltage generation circuit 160 outputs a voltage Vr5 to a voltage node NZ3. As a result, the voltage Vr5 is supplied to the resistor 56.

The resistor 56 has a resistance value R3.

Magnitude of an output voltage Vout of the driver DRV can be adjusted according to magnitude of the resistance value R3 of the resistor 56 and magnitude of the voltage Vr5.

In a case where an adjustment amount of the output voltage Vout is made large, the resistance value R3 is made small. In contrast, in a case where the adjustment amount of the output voltage Vout is made small, the resistance value R3 is made large. For example, in a case where the adjustment amount of the output voltage Vout may be a small amount, the resistor 56 having a large resistance value R3 is used. In this case, for example, the resistance value R3 of the resistor 56 is larger than the resistance value R2 of the resistor 51.

For example, in a case where the adjustment amount of the output voltage Vout is large, the resistance value R3 of the resistor 56 is made smaller than the resistance value R2 of the resistor 51.

In the present embodiment, a current Iin is expressed by following expression 5.

$$\text{Iin} = (N/M) \times \text{Ir} + (Vcenter - Vr5)/R3 \dots \text{(Expression 5)}$$

In expression 5, "Vr5" represents a voltage value of the voltage Vr5. "R3" represents a resistance value of the resistor 56.

The output voltage Vout of the driver DRV is expressed by following expression 6.

Vout = Vcenter + R1 $\times$ (N/M) $\times$ Ir + (R1/R3) $\times$ (Vcenter - Vr5) ... (Expression 6)       (Expression 6)

With the circuit in FIG. 13, in the present embodiment, monotonicity of DA conversion by the DA converter DAC in the DA conversion circuit 163 is guaranteed.

In the present embodiment, rise and fall of the output voltage Vout of the driver DRV in the driver circuit 162 can be controlled.

As described above, the semiconductor device of the present embodiment can improve the characteristics of the semiconductor device as in the first embodiment.

(4) Fourth Embodiment

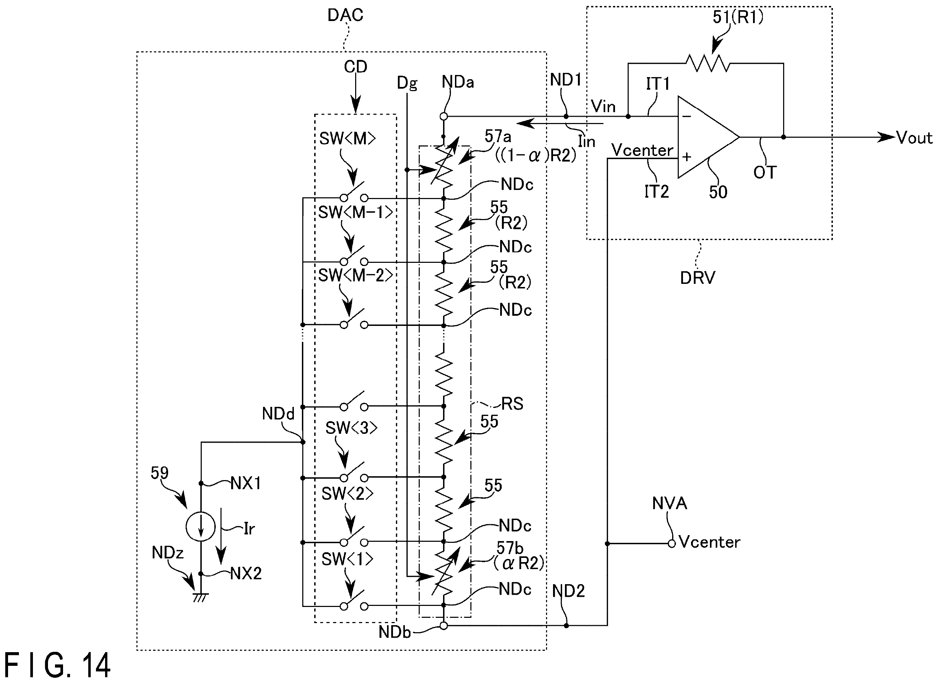

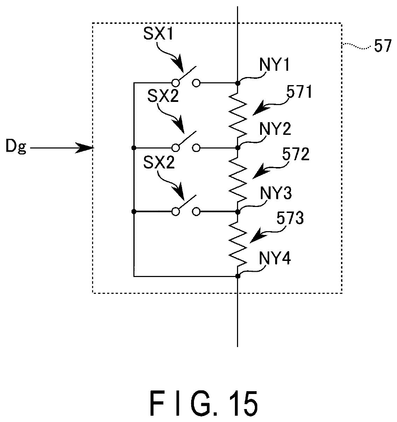

A semiconductor device of a fourth embodiment will be described with reference to FIGS. 14 and 15.

FIG. 14 is a diagram illustrating a configuration example of a DA conversion circuit in a semiconductor device (for example, a memory device) 1 of the present embodiment.

As illustrated in FIG. 14, a resistor string RS may include a variable resistor (variable resistance element) 57 (57a and 57b).

The variable resistor 57a is provided on one end side of the resistor string RS. For example, the variable resistor 57a is provided on an initial stage of the resistor string RS. One end of the variable resistor 57a is connected to a node NDa (and a node ND1). The other end of the variable resistor 57a is connected to one end of a resistor 55 via a node NDc.

The variable resistor 57a has a resistance value of magnification of 1-$\alpha$ with respect to a resistance value R2 of the resistor 55. The variable resistor 57a has a resistance value of (1-$\alpha$)R2.

The variable resistor 57b is provided on the other end side of the resistor string RS. For example, the variable resistor 57b is provided on a final stage of the resistor string RS. One end of the variable resistor 57b is connected to other end of the resistor 55 via the node NDc. The other end of the variable resistor 57b is connected to a node NDb (and a node ND2).

The variable resistor 57b has magnification of $\alpha$ with respect to the resistance value R2 of the resistor 55. The variable resistor 57b has a resistance value of $\alpha$R2.

A digital control circuit 191 of a sequencer 190 supplies a control signal (digital signal) Dg to the variable resistors 57a and 57b. Magnitude of magnification $\alpha$ of the variable resistors 57a and 57b is controlled by the control signal Dg.

For example, $\alpha$ may take a value in a range from 0 to 0.75. For example, the value of $\alpha$ is indicated by a 2-bit digital signal. In this case, the value of $\alpha$ can be set to any one of values 0, 0.25, 0.5, and 0.75 according to the value of the digital signal.

FIG. 15 is an equivalent circuit diagram illustrating an example of the variable resistor 57.

As illustrated in FIG. 15, the variable resistor 57 includes a plurality of resistors 571, 572, and 573 and a plurality of switches SX1, SX2, and SX3.

The plurality of resistors 571, 572, and 573 is connected in series. The number of the resistors 571, 572, and 573 is determined according to the value of $\alpha$, and is three in an example in FIG. 15. One end of the resistor 571 is connected to a node NY1. The other end of the resistor 571 is connected to a node NY2. One end of the resistor 572 is connected to the other end of the resistor 571 via the node NY2. The other end of the resistor 572 is connected to a node NY3. One end of the resistor 573 is connected to the other end of the resistor 572 via the node NY3. The other end of the resistor 573 is connected to a node NY4.

The plurality of switches SX1, SX2, and SX3 is connected to the resistors 571, 572, and 573. The number of switches SX1, SX2, and SX3 is determined according to the value of $\alpha$, and is three in an example in FIG. 15. One end of the switch SX1 is connected to the node NY1. The other end of the switch SX1 is connected to the node NY4. One end of the switch SX2 is connected to the node NY2. The other end of the switch SX2 is connected to the node NY4. One end of the switch SX3 is connected to the node NY3. The other end of the switch SX3 is connected to the node NY4.

In a case where the variable resistor 57 in FIG. 15 is the variable resistor 57a in FIG. 14, the node NY1 is connected to the node NDa, and the node NY4 is connected to the resistor 55 via the node NDc. In a case where the variable resistor 57 in FIG. 15 is the variable resistor 57b in FIG. 14, the node NY1 is connected to the resistor 55 via the node NDc, and the node NY4 is connected to the node NDb via the node NDc.

Each of the resistors 571, 572, and 573 has a resistance value R9. For example, magnitude of the resistance value R9 is equal to magnitude of 1/4 of the resistance value R2 (R2/4). In the variable resistor 57, any one switch SX of the plurality of switches SX1, SX2, and SX3 is turned on based on the digital signal Dg. As a result, in the variable resistor 57, a current is divided at a position of the switch SX in an on state.

As illustrated in FIG. 15, two variable resistors 57a and 57b each including three resistors 571, 572, and 573 can correspond to a digital value of two bits included in a code CD.

In the present embodiment, monotonicity of DA conversion by the DA converter DAC in the DA conversion circuit 163 is guaranteed.

In the present embodiment, in a case where the variable resistor 57 is applied to the resistor string RS of the DA converter DAC, the number of resistors 55 in the resistor string RS can be reduced. As a result, the semiconductor device 1 of the present embodiment can downsize the DA converter DAC.

As a result, the semiconductor device 1 of the present embodiment can reduce an area of the circuit including a plurality of DA converter DAC. Accordingly, the semiconductor device 1 of the present embodiment can reduce a manufacturing cost (chip cost) of the semiconductor device.

(5) Fifth Embodiment

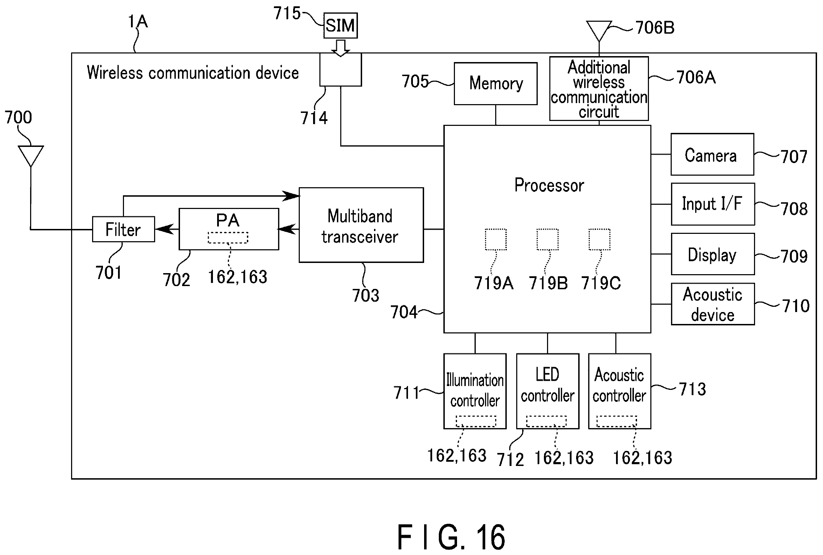

A semiconductor device of a fifth embodiment will be described with reference to FIG. 16.

The semiconductor device of the embodiment may be a device other than a memory device. For example, the semiconductor device of the present embodiment is a wireless communication device.

FIG. 16 is a block diagram illustrating a configuration example of a wireless communication device 1A of the present embodiment.

The wireless communication device 1A of the present embodiment includes an antenna 700, a filter 701, a power amplifier 702, a multiband transceiver 703, and a processor 704.

The wireless communication device 1A of the present embodiment includes a memory module 705, an additional wireless communication circuit 706A, an antenna 706B, a camera 707, an input interface 708, a display 709, an acoustic device 710, an illumination controller 711, a light emitting device (LED) controller 712, an acoustic controller 713 and the like.

The antenna 700 receives a radio frequency signal (radio wave) from outside of the wireless communication device 1A. The antenna 700 transmits a radio frequency signal generated in the wireless communication device 1A to the outside of the wireless communication device 1A.

The filter 701 performs various types of filtering processing on the radio frequency signal supplied from the antenna 700 or the power amplifier 702. For example, the filter 701 can switch a transmission path and a reception path of the radio frequency signal.

The power amplifier 702 amplifies a signal transmitted to the outside of the wireless communication device 1A. The power amplifier 702 amplifies power for a signal from the multiband transceiver 703. For example, the power amplifier 702 includes a driver circuit 162 and a DA conversion circuit 163 of the above-described embodiment. For example, in the DA conversion circuit 163 used for the power amplifier 702, a current source circuit 59 has a circuit configuration in any one of FIGS. 8, 9, and 10.

The multiband transceiver 703 performs modulation processing and demodulation processing on the radio frequency signal. The multiband transceiver 703 performs the demodulation processing on the signal received by the antenna 700. As a result, a baseband signal is extracted from the received signal. The multiband transceiver 703 performs the modulation processing on the baseband signal generated in the wireless communication device 1A. As a result, the modulated signal is transmitted from the antenna 700 to the outside of the wireless communication device 1A via the power amplifier 702 and the filter 701.

The multiband transceiver 703 is configured to execute signal processing simultaneously by using a plurality of carrier frequencies through carrier aggregation. For example, the multiband transceiver performs various types of signal processing based on various standards of a third generation mobile communication system such as a wideband code division multiple access (WCDMA) (registered trademark) standard, various standards of a fourth generation mobile communication system such as a long term evolution (LTE) (registered trademark)-Advanced standard, a standard of a fifth generation mobile communication system, and a sixth generation mobile communication system.

The processor 704 performs various types of calculation processing and control processing in the wireless communication device 1A. The processor 704 includes, for example, a central processing unit (CPU) 719A, a baseband processor 719B, an application processor 719C and the like.

The CPU 719A performs control processing regarding an entire wireless communication device 1A and various types of processing regarding data.

The baseband processor 719B performs various types of control regarding wireless communication such as signal generation, signal demodulation and modulation control, signal encoding, and frequency shift.

The application processor 719C manages software (program) in the wireless communication device 1A.

The memory module 705 stores various data used for the wireless communication device 1A. The memory module 705 includes a volatile semiconductor memory such as SRAM or DRAM and/or a non-volatile semiconductor memory such as a flash memory.

An additional wireless communication circuit 706A executes a wireless communication function supplementarily used in the wireless communication device 1A, such as a global positioning system (GPS), a wireless local area network (WLAN), and Bluetooth (registered trademark). The additional wireless communication circuit 706A communicates with a device outside the wireless communication device 1A via the antenna 706B.

The camera 707 can shoot a still image and a moving image. The camera 707 can read a one-dimensional code and a two-dimensional code. For example, the camera 707 includes an image sensor.

The input interface 708 functions as an input interface of a user to the wireless communication device 1A. For example, the input interface 708 is a touch panel, a keypad or the like. The input interface may be a keyboard or a mouse.

The display 709 displays information received by the wireless communication device 1A and information generated by the wireless communication device 1A to the user. The display 709 is, for example, a liquid crystal display such as a touch panel or an organic electro luminescence (EL) display.

The acoustic device 710 provides the user with voice information received by the wireless communication device 1A and voice information generated by the wireless communication device 1A. The acoustic device 710 includes a microphone and a speaker.

The illumination controller 711 controls illuminance of the display 709. For example, the illumination controller 711 includes a driver circuit 162 and a DA conversion circuit 163 of the above-described embodiment. In a case where the DA conversion circuit 163 is used for the illumination controller 711, a circuit 59A in FIG. 8 or a circuit 59B in FIG. 9 is used for the current source circuit 59 of the DA converter DAC.

The light emitting device (for example, LED) controller 712 controls a light emission intensity of a light emitting device (for example, a light emitting diode) such as lighting (not illustrated) of the wireless communication device 1A. For example, the light emitting device controller 712 includes the driver circuit 162 and the DA conversion circuit 163 of the above-described embodiment. In a case where the DA conversion circuit 163 is used for the light emitting device controller 712, the circuit 59A in FIG. 8 or the circuit 59B in FIG. 9 is used for the current source circuit 59 of the DA converter DAC.

The acoustic controller 713 controls a voice signal of the acoustic device 710. For example, the acoustic controller 713 includes the driver circuit 162 and the DA conversion circuit 163 of the above-described embodiment. In a case where the DA conversion circuit 163 is used in the acoustic controller 713, the circuit 59C in FIG. 10 is preferably used for the current source circuit 59 of the DA converter DAC so that the voice signal can be controlled by a current of positive polarity and a current of negative polarity.

For example, a SIM card 715 is inserted into a slot 714 of the wireless communication device 1A. The SIM card 715 provides the wireless communication device 1A with identification information of the user who uses the wireless communication device 1A.

The wireless communication device 1A is, for example, a smartphone, a personal digital assistant (for example, a tablet device), a laptop PC, or an unmanned aerial vehicle.

As described above, the DA converter DAC of the DA conversion circuit 163 and the driver DRV of the driver circuit 162 of the above-described embodiment are applied to the wireless communication device 1A as the semiconductor device of the present embodiment.

The semiconductor device of the present embodiment can obtain the effects similar to those of the above-described embodiment.

(6) Sixth Embodiment

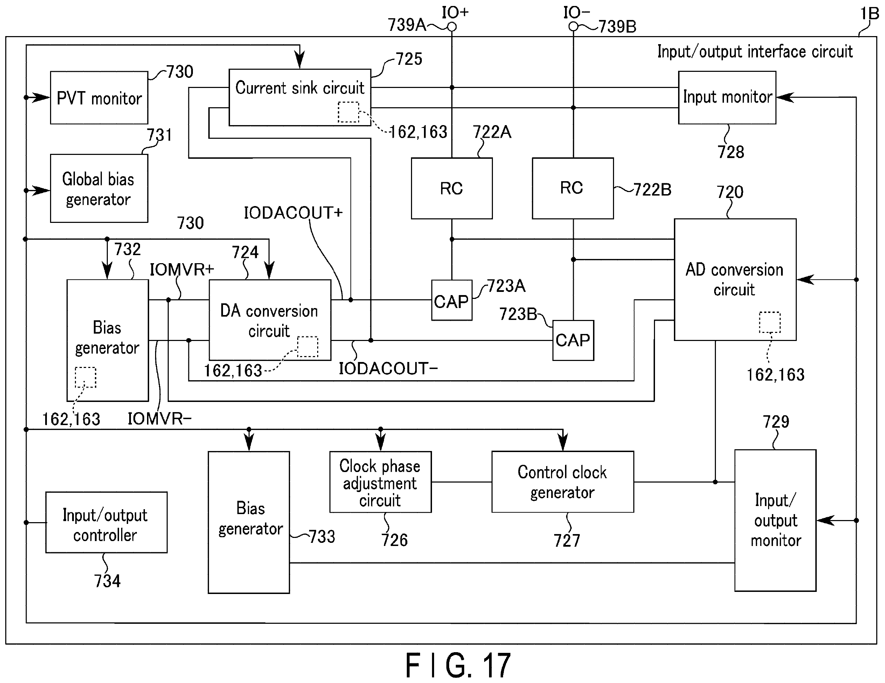

A semiconductor device of a sixth embodiment will be described with reference to FIG. 17.

The semiconductor device of the embodiment may be an input/output interface circuit. The input/output interface circuit may be a circuit compatible with optical or wired communication such as Ethernet (registered trademark), or may be a circuit compatible with wireless communication such as RF.

FIG. 17 is a block diagram illustrating a configuration example of an input/output interface circuit 1B of the present embodiment.

In FIG. 17, the input/output interface circuit (transceiver) 1B is a differential transmission type input/output interface circuit. The input/output interface circuit 1B includes a pair of differential input/output terminals 739A and 739B. The input/output interface circuit 1B receives differential signals IO+ and IO- and transmits the differential signals IO+ and IO- via the differential input/output terminals 739A and 739B. The two differential signals IO+ and IO- have a mutual complementary relationship.

In the present embodiment, the two input/output terminals 739A and 739B forming a pair for differential transmission are referred to as a differential input/output terminal pair. A pair of signal lines for differential transmission in the input/output interface circuit 1B is referred to as a differential transmission path.

The input/output interface circuit 1B includes an analog-digital conversion circuit (AD conversion circuit) 720, resistor-capacitor circuits 722A and 722B, capacitor circuits 723A and 723B, a digital-analog conversion circuit (DA conversion circuit) 724, a current sink circuit 725, a clock phase adjustment circuit 726, a control clock generator 727, an input monitor 728, an input/output monitor 729, a PVT monitor 730, a global bias generator 731, bias generators 732 and 733, an input/output controller 734 and the like.

The AD conversion circuit 720 receives the differential signals IO+ and IO- input to the input/output interface circuit 1B via the resistor-capacitor circuits (RC circuits) 722A and 722B. The AD conversion circuit 720 receives reference signals IOMVR+ and IOMVR- from the bias generator 732. The AD conversion circuit 720 converts the signals IO+ and IO- from analog signals to digital signals using the reference signals IOMVR+ and IOMVR-.

For example, the AD conversion circuit 720 includes a driver circuit 162 and a DA conversion circuit 163 of the above-described embodiment. For example, in a case where the AD conversion circuit 720 has a successive approximation type circuit configuration, the AD conversion circuit 720 includes a DA conversion circuit, a comparison circuit, and a control circuit. The DA conversion circuit 163 of the embodiment is used for a DA conversion circuit of the successive approximation type AD conversion circuit 720.

RC circuits (hereinafter, also referred to as RC networks) 722A and 722B are provided so as to correspond to the input/output terminals 739A and 739B, respectively. The RC circuit 722A is connected to a signal path of the input/output terminal 739A. The RC circuit 722B is connected to a signal path of the input/output terminal 739B. The RC circuits 722A and 722B control a time constant regarding the supplied signal. The RC circuits 722A and 722B include a resistor and a capacitor, and can be designed (programmed) after mounting.

The capacitor circuits 723A and 723B are provided between the RC circuits 722A and 722B and the DA conversion circuit 724. The capacitor circuit 723A is connected to the RC circuit 722A. The capacitor circuit 723B is connected to the RC circuit 722B. The capacitor circuits 723A and 723B include a plurality of capacitors. The capacitor circuits 723A and 723A smooth signals.

The DA conversion circuit 724 receives the digital signals. The DA conversion circuit 724 receives the reference signals IOMVR+ and IOMVR- from the bias generator 732.

The DA conversion circuit 724 generates an analog signal IODACOUT+ and an analog signal IODACOUT- based on the received digital signals and reference signals IOMVR+ and IOMVR-. The two analog signals IODACOUT+ and IODACOUT- are signals having a mutual complementary relationship.

The DA conversion circuit 724 transmits the generated analog signals IODACOUT+ and IODACOUT- to the input/output terminals 739A and 739B via the capacitor circuit 723 and the RC circuit 722. The DA conversion circuit 724 transmits the analog signals IODACOUT+ and IODACOUT- to the current sink circuit 725.

The signals IODACOUT+ and IODACOUT- are output to the outside of the input/output interface circuit 1B as the differential signals IO+ and IO-.

The DA conversion circuit 724 includes the driver circuit 162 and the DA conversion circuit 163 of the above-described embodiment. The DA conversion circuit 724 generates the analog signal IODACOUT+ and the analog signal IODACOUT- from the digital signals and the reference signals IOMVR+ and IOMVR- using the driver circuit 162 and the DA conversion circuit 163 of the above-described embodiments.

For example, the DA conversion circuit 724 generates the analog signal IODACOUT+ and the analog signal IODACOUT-by using two DA conversion circuits 163. Alternatively, the DA conversion circuit 724 inverts and amplifies the analog signal IODACOUT+ generated by one DA conversion circuit 163 by an operational amplifier to generate the analog signals IODACOUT- forming a pair.

The current sink circuit 725 controls magnitude of a current flowing through the input/output terminal 739 and the signal line within an allowable range based on specifications of the input/output interface circuit 1B. For example, the current sink circuit 725 includes the driver circuit 162 and the DA conversion circuit 163 of the above-described embodiment.

The clock phase adjustment circuit 726 adjusts a phase of a reference clock signal and generates various clock signals used for the input/output interface circuit 1B.

The control clock generator 727 generates a control clock used for the AD conversion circuit 720 and the input/output monitor 729.

The input monitor 728 monitors the signals IO+ and IO-at the input/output terminals 739A and 739B.

The input/output monitor 729 monitors a plurality of clock signals from the control clock generator 727.

The PVT monitor 730 monitors various band gap voltages and bias voltages in the input/output interface circuit 1B. The band gap voltage is a voltage (reference voltage) serving as a reference of a voltage amplitude of a signal. The bias voltage is a voltage for operation of each circuit block in the input/output interface circuit 1B.

The global bias generator 731 generates a main bias voltage used for each circuit block in the input/output interface circuit 1B.

The bias generator 732 generates voltages serving as a reference of the bias voltages (bias signals) of the AD conversion circuit 720 and the DA conversion circuit 724. The bias generator 732 includes, for example, the driver circuit 162 and the DA conversion circuit 163 of the above-described embodiment. The bias generator 732 generates voltages serving as a reference of the bias voltages (bias signals) based on the control signal received from the input/output controller 734 using the driver circuit 162 and the DA conversion circuit 163 of the above-described embodiment.

The bias generator 733 generates the bias voltages for the AD conversion circuit 720 and the input/output controller 734.

The input/output controller 734 generates the control signal for each circuit block in the input/output interface circuit 1B. The input/output controller 734 supplies the generated control signal to each circuit block.

As described above, a DA converter DAC of the DA conversion circuit 163 and a driver DRV of the driver circuit 162 of the above-described embodiment are applied to the input/output interface circuit 1B as the semiconductor device of the present embodiment.

Therefore, the semiconductor device of the present embodiment can obtain the effects similar to those of the above-described embodiment.

(7) Seventh Embodiment

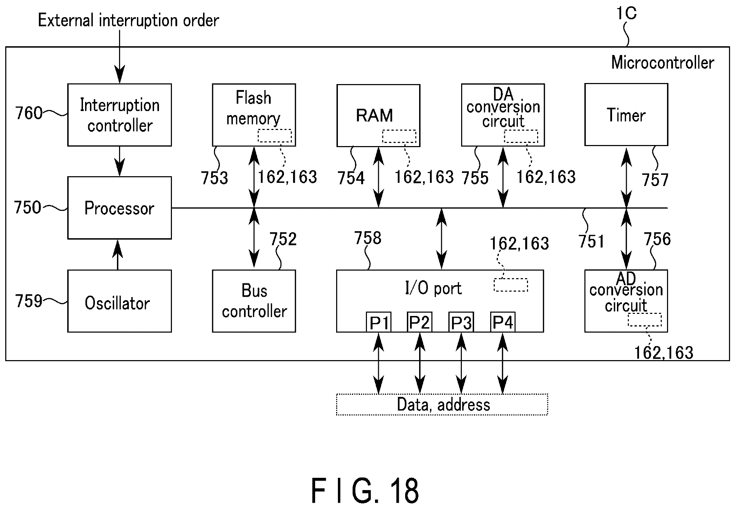

A semiconductor device of a seventh embodiment will be described with reference to FIG. 18.

The semiconductor device of the embodiment may be a microcontroller.

FIG. 18 is a block diagram illustrating a configuration example of a microcontroller 1C of the present embodiment.

The microcontroller 1C of the present embodiment includes a system on chip (SoC), a system in package (SIP), and a system on package (SoP). The microcontroller 1C is used in an embedded system. For example, the microcontroller 1C of the present embodiment is an in-vehicle device. Note that, the microcontroller 1C may be used for home electric appliances, computers, industrial machines, railway vehicles, aircraft, ships and the like.

The microcontroller 1C is classified based on a bus width, a memory structure, an order set and the like. The bus width indicates a size of a data bus. For example, the microcontroller 1C is classified into an 8-bit microcontroller, a 16-bit microcontroller, or a 32-bit microcontroller based on the bus width. The microcontroller 1C can obtain better performance with a high bus width.

As illustrated in FIG. 18, the microcontroller 1C includes a processor 750, a bus 751, a bus controller 752, memory devices 753 and 754, a DA conversion circuit 755, an AD conversion circuit 756, a timer 757, an input/output (I/O) port 758, an oscillator 759, an interruption controller 760 and the like.

The processor 750 executes various types of processing in the microcontroller 1C. The processor 750 performs various types of processing on supplied data. The processor 750 is, for example, a CPU.

The bus 751 is connected to the processor 750, the bus controller 752, the memory devices 753 and 754, the DA conversion circuit 755, the AD conversion circuit 756, the timer 757, and the input/output port 758. The bus 751 is a signal and data transmission path in the microcontroller 1C.

The bus controller 752 controls the bus 751. The bus controller 752 may be provided in the processor 750.

The memory device 753 stores data in a non-volatile manner. The memory device 753 is, for example, a NOR flash memory. For example, the NOR flash memory as the memory device 753 includes a driver circuit 162 and a DA conversion circuit 163 of the above-described embodiment. Note that, the memory device 753 may be the above-described NAND flash memory.

The memory device 754 temporarily stores data. The memory device 753 is, for example, a random access memory such as SRAM or DRAM. For example, the random access memory as the memory device 753 includes the driver circuit 162 and the DA conversion circuit 163 of the above-described embodiment.

The DA conversion circuit 755 converts a digital signal (digital value) to an analog signal (analog value). For example, the DA conversion circuit 755 includes the driver circuit 162 and the DA conversion circuit 163 of the above-described embodiment.

The AD conversion circuit 756 converts an analog signal to a digital signal. For example, the AD conversion circuit 756 includes the driver circuit 162 and the DA conversion circuit 163 of the above-described embodiment.

The timer 757 manages time (operation timing) in the microcontroller 1C.

The input/output port 758 functions as a data interface circuit in the microcontroller 1C. The input/output port 758 includes, for example, four ports P1, P2, P3, and P4. The number of ports of the input/output port 758 may be three or smaller, or may be five or larger.

The input/output port 758 receives data, an address, and a signal from outside of the microcontroller 1C via the ports P1, P2, P3, and P4. The input/output port 758 transmits the data and signal to the outside of the microcontroller 1C via the ports P1, P2, P3, and P4.

For example, the input/output port 758 includes an interface based on a general purpose input/output (GPIO) standard, a universal synchronous/asynchronous receiver transmitter (USART) standard, an inter-integrated circuit (I2C) standard or the like.

For example, the input/output port 758 includes the driver circuit 162 and the DA conversion circuit 163 of the above-described embodiment.

The oscillator 759 outputs a clock signal as a synchronization signal to the processor 750. The clock signal has a certain cycle (clock number). As a result, the processor 750 performs various types of processing at a timing synchronized with the clock signal. The cycle of the clock signal is, for example, 4 MHz, 8 MHz, 12 MHz, 24 MHz or the like.

The interruption controller 760 receives an external interruption order. For example, the interruption controller 760 includes a register for managing a status of an interruption request.

The interruption controller 760 transmits various interruption requests to the processor 750 based on the received external interruption order. In response to the interruption request, the processor 750 temporarily suspends processing being executed and executes processing of the interruption request. After completion of the processing of the interruption request, the processor 750 resumes the suspended processing.

As described above, a DA converter DAC of the DA conversion circuit 163 and a driver DRV of the driver circuit 162 of the above-described embodiment are applied to the microcontroller 1C as the semiconductor device of the present embodiment.

Therefore, the semiconductor device of the present embodiment can obtain the effects similar to those of the above-described embodiment.

(8) Others

The semiconductor device 1 of the embodiment is not limited to the above-described various devices. For example, the semiconductor device 1 of the embodiment may be a random access memory, a read-only memory, an image sensor, an application specific integrated circuit (ASIC), a processor or the like.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. A semiconductor device (160) comprising:

    an operational amplifier (50) including a first input terminal (IT1), a second input terminal (IT2), and an output terminal (OT), the operational amplifier that outputs a first voltage (Vout) from the output terminal;
    a first resistor (51) including one end connected to the first input terminal and an other end connected to the output terminal;
    a plurality of second resistors (55<1> to 55<M>) including one end connected to the first input terminal, the plurality of second resistors connected in series;
    a plurality of switches (SW<1> to SW<M>) each including one end connected to a first node (NDc) between two adjacent resistors of the plurality of second resistors and an other end connected to a second node (NDd), the plurality of switches that receives a digital code (CD); and
    a current source circuit (59) connected between the second node and a third node (NDz), wherein
    a switch out of the plurality of switches is turned on based on the digital code, and
    the current source circuit causes a first current (Ir) to flow from a part or all of the plurality of second resistors to the third node via the switch in an on state.

2. The semiconductor device according to claim 1, wherein
the second input terminal is connected to an other end of the plurality of second resistors.

3. The semiconductor device according to claim 1, wherein

    the first voltage is determined based on N and M, and
    the M is the number of the plurality of second resistors.

4. The semiconductor device according to claim 3, wherein
the N represents a value of the digital code allocated to the switch set to the on state out of the plurality of switches.

5. The semiconductor device according to claim 3, wherein
the N represents the number of resistors that are not present between the one end of the plurality of second resistors and the switch in the on state out of the plurality of second resistors.

6. The semiconductor device according to claim 3, wherein
the N represents the number of resistors that are present between an other end of the plurality of second resistors and the switch in the on state.

7. The semiconductor device according to claim 3, wherein

the plurality of second resistors includes a plurality of connection nodes, and
the N is a value indicating a position of a connection node connected to the current source circuit via the switch in the on state out of the plurality of connection nodes.

8. The semiconductor device according to claim 2, wherein

the first voltage is expressed by following expression A

$$\text{Vout} = \text{Vcenter} + \text{R1} \times (\text{N/M}) \times \text{Ir} \dots (\text{Expression A})$$

wherein the M represents the number of the plurality of second resistors, the N represents the number of second resistors that are not present between the one end of the plurality of second resistors and the switch in the on state out of the plurality of second resistors, the Vcenter represents a voltage supplied to the second input terminal, the R1 represents a resistance value of the first resistor, and the Ir represents the first current.

9. The semiconductor device according to claim 1, wherein

the second input terminal is connected to a first voltage node to which a second voltage is supplied, and
the other end of the plurality of second resistors is electrically separated from the first voltage node and is connected to a second voltage node to which a third voltage is supplied.

10. The semiconductor device according to claim 9, wherein

the first voltage is expressed by following expression B

Vout = Vc1 + R1 $\times$ (N/M) $\times$ Ir + (R1/R2) $\times$ (Vc1 - Vc2)/M ... (Expression B)       (Expression B)

wherein the M represent the number of the plurality of second resistors, the N represents the number of second resistors that are not present between the one end of the plurality of second resistors and the switch in the on state out of the plurality of second resistors, the Vc1 represents a voltage value of the second voltage, the Vc2 represents a voltage value of the third voltage, the R1 represents a resistance value of the first resistor, the R2 represents a resistance value of one of the plurality of second resistors, and the Ir represents the first current.

11. The semiconductor device according to claim 1, further comprising:

a third voltage node to which a fourth voltage is supplied; and
a third resistor connected between the first input terminal and the third voltage node.

12. The semiconductor device according to claim 11, wherein

the first voltage is expressed by following expression C

Vout = Vcenter + R1 $\times$ (N/M) $\times$ Ir + (R1/R3) $\times$ (Vcenter - Vr5) ... (Expression C)       (Expression C)

wherein the M represent the number of the plurality of second resistors, the N represents the number of second resistors that are not present between the one end of the plurality of second resistors and the switch in the on state out of the plurality of second resistors, the Vcenter represents a voltage supplied to the second input terminal, the R1 represents a resistance value of the first resistor, the R3 represents a resistance value of the third resistor, the Vr5 represents the fourth voltage, and the Ir represents the first current.

13. The semiconductor device according to claim 1, wherein

a resistor at one end out of the plurality of second resistors is a first variable resistor,
a resistor at an other end out of the plurality of second resistors is a second variable resistor,
the first variable resistor has a variable ratio of 1-$\alpha$ with respect to a resistance value of a resistor out of the plurality of second resistors, and
the second variable resistor has a variable ratio of $\alpha$ with respect to the resistance value of a resistor out of the plurality of second resistors.

14. The semiconductor device according to claim 1, wherein
the current source circuit causes a current having polarity in one direction to flow.

15. The semiconductor device according to claim 1, wherein
the current source circuit causes a current having bipolarity to flow.

16. The semiconductor device according to claim 1, further comprising:
a communication circuit that transmits and receives a wireless signal.

17. The semiconductor device according to claim 1, further comprising:
an input/output terminal pair for differential transmission.

18. The semiconductor device according to claim 1, further comprising:
a processor that executes processing on data supplied via a port and interruption processing supplied from outside.

19. A memory device (1) comprising:

a memory cell (MT) that stores data; and
a voltage generation circuit (160) that generates a voltage for an operation of the memory cell; wherein
the voltage generation circuit includes:

an operational amplifier (50) including a first input terminal (IT1), a second input terminal (IT2), and an output terminal (OT), the operational amplifier that outputs a first voltage (Vout) from the output terminal;
a first resistor (51) including one end connected to the first input terminal and an other end connected to the output terminal;
a plurality of second resistors (55<1> to 55<M>) including one end connected to the first input terminal, the plurality of second resistors connected in series;
a plurality of switches (SW<1> to SW<M>) each including one end connected to a first node (NDc) between two adjacent resistors of the plurality of second resistors and an other end connected to a second node (NDd), the plurality of switches that receives a digital code (CD); and
a current source circuit (59) connected between the second node and a third node (NDz),
a switch out of the plurality of switches is turned on based on the digital code, and
the current source circuit causes a first current (Ir) to flow from a part or all of the plurality of second resistors to the third node via the switch in an on state.

20. The memory device according to claim 19, further comprising:

a temperature sensor that measures temperature of the memory device, wherein
the digital code is a value according to a measurement result of the temperature measured by the temperature sensor.

F I G. 1

F I G. 2

F I G. 3

F I G. 4

FIG. 5

F I G. 6

EP 4 589 594 A1

F I G. 7

EP 4 589 594 A1

F I G. 8

FIG. 9

F I G. 10

F I G. 11

34

F I G. 12

F I G. 13

F I G. 14

EP 4 589 594 A1

F I G. 15

F I G. 16

F I G. 17

External interruption order

1C

Microcontroller

760 — Interruption controller

Flash memory

RAM

DA conversion circuit

Timer

753    162,163    754    162,163    755    162,163    757

750 — Processor

752    758    162,163    751    756

759 — Oscillator

Bus controller

I/O port

P1  P2  P3  P4

AD conversion circuit

162,163

Data, address

F I G. 18

## INTERNATIONAL SEARCH REPORT

International application No.

**PCT/JP2022/034749**

| A. | CLASSIFICATION OF SUBJECT MATTER |
|---|---|

*G11C 16/30*(2006.01)i; *G11C 7/04*(2006.01)i; *H03M 1/78*(2006.01)i
FI:   G11C16/30 120; G11C7/04; H03M1/78

According to International Patent Classification (IPC) or to both national classification and IPC

| B. | FIELDS SEARCHED |
|---|---|

Minimum documentation searched (classification system followed by classification symbols)

G11C16/30; G11C7/04; H03M1/78

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| A | JP 54-152953 A (TOKYO SHIBAURA ELECTRIC CO., LTD.) 01 December 1979 (1979-12-01)<br>p. 2, upper right column, line 7 to lower left column, line 2, fig. 1 | 1-20 |
| A | JP 4-23517 A (HITACHI, LTD.) 27 January 1992 (1992-01-27)<br>p. 3, upper left column, line 14 to lower left column, line 3, fig. 1, 3 | 1-20 |

☐ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **07 November 2022** | **22 November 2022** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

## INTERNATIONAL SEARCH REPORT
### Information on patent family members

International application No.

**PCT/JP2022/034749**

| Patent document cited in search report | | | Publication date (day/month/year) | Patent family member(s) | Publication date (day/month/year) |
|---|---|---|---|---|---|
| JP | 54-152953 | A | 01 December 1979 | (Family: none) | |
| JP | 4-23517 | A | 27 January 1992 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2002076897 A